# EUROPÄISCHE PATENTSCHRIFT

(11) **EP 3 230 295 B1**
(45) Veröffentlichungstag und Bekanntmachung des Hinweises auf die Patenterteilung: **31.07.2019**
(21) Anmeldenummer: 15816100.0
(22) Anmeldetag: 07.12.2015
(51) Int. Cl.: C09D 5/24, H01L 51/50, C07F 9/572, C07F 9/6506, C07F 9/6524, C07F 9/6593, C07F 9/6584, C09K 11/00, H01L 51/00, H01L 29/00, C07F 9/06

(54) **AMINOPHOSPHAZEN-BASEN ALS N-DOTIERSTOFFE IN DER ORGANISCHEN ELEKTRONIK**
AMINO PHOSPHAZENE BASES AS N-DOPANTS IN ORGANIC ELECTRONICS
BASES AMINOPHOSPHAZÈNE EN TANT QU'AGENTS DE DOPAGE DE TYPE N EN ÉLECTRONIQUE ORGANIQUE

(30) Priorität: 19.01.2015 DE 102015200699
(43) Veröffentlichungstag der Anmeldung: 18.10.2017
(73) Patentinhaber: Siemens Aktiengesellschaft, 80333 München (DE)
(72) Erfinder: KESSLER, Florian, 91315 Höchstadt an der Aisch (DE); REGENSBURGER, Stefan, 92318 Neumarkt (DE); SCHMID, Günter, 91334 Hemhofen (DE)
(86) Internationale Anmeldenummer: PCT/EP2015/078749
(87) Internationale Veröffentlichungsnummer: WO 2016/116202

(56) Entgegenhaltungen:
- JP-A- H0 512 990
- DATABASE CA [Online] CHEMICAL ABSTRACTS SERVICE, COLUMBUS, OHIO, US; 2008, HARASHINA, HATSUHIKO ET AL: "Odorless stable polyacetals, their manufacture including heat treatment, their compositions, and their moldings", XP002754874, gefunden im STN Database accession no. 2008:185532
- LAWSON GAVIN T ET AL: "Cis-trihydrogen cyclotriphosphazenates-acidic anions in strongly basic media", CHEMICAL COMMUNICATIONS - CHEMCOM; [6015D], ROYAL SOCIETY OF CHEMISTRY, GB, Nr. 5, 2000, Seiten 341-342, XP002444815, ISSN: 1359-7345, DOI: 10.1039/A908954C
- JAMIE F. BICKLEY ET AL: "Supramolecular variations on a molecular theme: the structural diversity of phosphazenes (RNH)6P3N3 in the solid state", DALTON TRANSACTIONS: THE INTERNATIONAL JOURNAL FOR INORGANIC, ORGANOMETALLIC AND BIOINORGANIC CHEMISTRY, Nr. 7, 24. März 2003 (2003-03-24), Seiten 1235-1244, XP055251765, GB ISSN: 1477-9226, DOI: 10.1039/b212308h
- VORONTSOV I I ET AL: "X-ray crystal structures and DFT calculations of differently charged aminocyclophosphazenes", JOURNAL OF MOLECULAR STRUCTURE, ELSEVIER, AMSTERDAM, NL, Bd. 928, Nr. 1-3, 30. Juni 2009 (2009-06-30), Seiten 1-11, XP026159856, ISSN: 0022-2860, DOI: 10.1016/J.MOLSTRUC.2009.03.002 [gefunden am 2009-03-12]
- JEAN-LUC BUTOUR ET AL: "Spectrofluorometric and spectrophotometric investigations of cyclophosphazene-DNA complexes", JOURNAL OF MOLECULAR STRUCTURE., Bd. 65, 1980, Seiten 51-60, XP055251784, NL ISSN: 0022-2860, DOI: 10.1016/0022-2860(80)85179-9
- AZUSA KONDOH ET AL: "Phosphazene-catalyzed intramolecular cyclization of nitrogen-tethered alkynyl esters", CHEMICAL COMMUNICATIONS - CHEMCOM, Bd. 49, Nr. 87, 2013, Seite 10254, XP055251786, GB ISSN: 1359-7345, DOI: 10.1039/c3cc46100a
- REINHARD SCHWESINGER ET AL: "Peralkylierte Polyaminophosphazene -extrem starke neutrale Stickstoffbasen", ANGEWANDTE CHEMIE, Bd. 99, Nr. 11, 1987, Seiten 1212-1214, XP055251813, DE ISSN: 0044-8249, DOI: 10.1002/ange.19870991134
- IVARI KALJURAND ET AL: "Acid-Base Equilibria in Nonpolar Media. 4. Extension of the Self-Consistent Basicity Scale in THF Medium. Gas-Phase Basicities of Phosphazenes", THE JOURNAL OF ORGANIC CHEMISTRY, Bd. 68, Nr. 26, 2003, Seiten 9988-9993, XP055254127, US ISSN: 0022-3263, DOI: 10.1021/jo034537h
- Pamela Schrögel ET AL: "Phosphazene-Based Host Materials for the Use in Blue Phosphorescent Organic Light-Emitting Diodes", Chemistry of materials, vol. 23, no. 22, 22 November 2011 (2011-11-22), pages 4947-4953, XP055561936, ISSN: 0897-4756, DOI: 10.1021/cm201940f

## Beschreibung

Die vorliegende Erfindung betrifft ein Verfahren zur Herstellung n-leitender organisch elektrischer Schichten gekennzeichnet durch einen n-Dotierstoff zur Dotierung organischer Elektronentransportmaterialien, wobei der n-Dotierstoff mindestens eine Aminophosphazen-Gruppe nach Formel 1 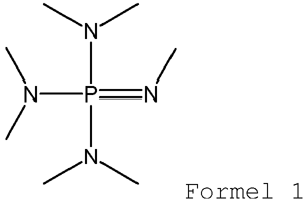 mit 4 an ein Phosphor-Atom gebundenen Stickstoffen aufweist.

### Stand der Technik

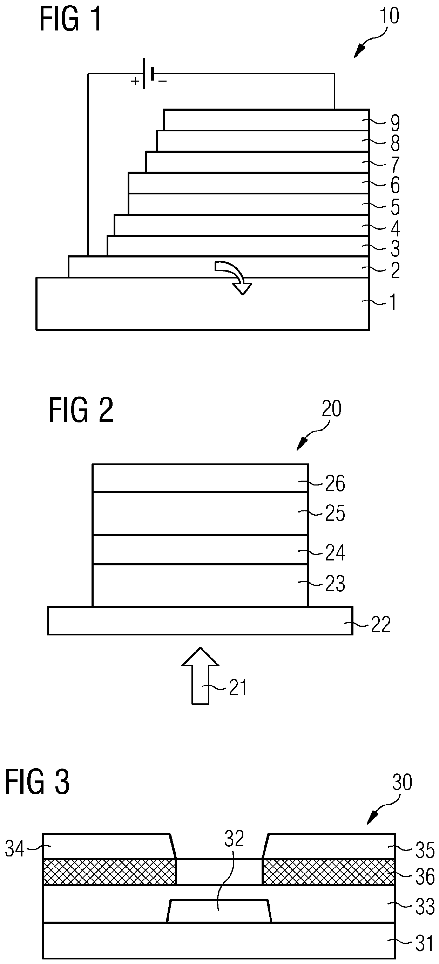

Üblicherweise gilt für Bauelemente der organischen Elektronik, dass ihre Effizienz umso höher liegt, je geringer der Spannungsabfall über die in diesen Bauteilen enthaltenen Transportschichten mit p-(Loch)- bzw. n-(Elektronen)-Leitfähigkeit ist. Dieser funktionale Zusammenhang gilt insbesondere bei organischen Leuchtdioden (schematischer Schichtaufbau dargestellt in Figur 1) und organischen Solarzellen (Figur 2). Für organische Feldeffekt-Transistoren (Figur 3) gelten ähnliche Zusammenhänge, wobei in diesen Fällen insbesondere die Effizienz der Injektion von Ladungsträgern von der Größe der Kontaktwiderstände abhängt. Ist man in der Lage diese zu minimieren, so erhöht man die effektive Mobilität des Halbleiters. Neben dem Einsatz geeigneter elektrisch leitender organischer Materialien hat sich dabei in der Technik durchgesetzt, dass zusätzliche Stoffe in die Schichten eingebracht werden, welche bewirken, dass die intrinsische Leitfähigkeit dieser Materialien erhöht wird. Je nach gewünschtem Zweck unterscheidet man dabei p- oder n-Dotanden, welche jeweils die p- oder die n-Leitfähigkeit von Transport-/Kontaktschichten verbessern. Die Zahl der verfügbaren n-Dotierstoffe für diese organisch elektronischen Bauelemente ist sehr begrenzt, was die Ausgestaltungsmöglichkeiten und derzeitige technische Leistungsfähigkeit organischer Bauelemente limitiert. Deshalb ist neben der Anwendung geeigneter Dotierstoffe in OLEDs, die Nutzung dieser in Feldeffekttransistoren als Kontaktdotierung, insbesondere bei komplementären Schaltkreisen bzw. in Bipolar-Bauelementen von großer Bedeutung.

In der Literatur finden sich einige Stellen, welche sich mit der Synthese und den Eigenschaften von Phosphazenen beschäftigen. So beispielsweise das Buch "Superbases for Organic Synthesis - Guanidines, Amidines, Phosphazenes and Related Organocatalysts" von Tsutomo Ishikawa (WILEY, 2009, ISBN: 978-0-470-51800-7). Des Weiteren wird dieser Themenkomplex beispielsweise auch in Núñez et al. J. Org. Chem. 1996, 61, 8386 behandelt, welcher u.a. die Synthese von Hexaimidazolylcyclotriposphazen beschreibt. Einsatzgebiete dieser Substanzen in der organischen Elektronik werden dabei nicht genannt.

In der Patentliteratur wird der Einsatz speziell substituierter Phosphazene in der organischen Elektronik als Elektronenleiter angeführt. So offenbart zum Beispiel die WO 2009/153276 A1 eine organische Leuchtdiode, enthaltend mindestens eine cyclische Phosphazenverbindung nach folgender Formel 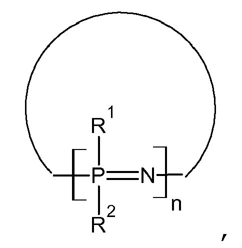 eine Licht-emittierende Schicht aufgebaut aus mindestens einem Matrixmaterial und mindestens einem Emittermaterial, wobei das mindestens eine Matrixmaterial mindestens eine cyclische Phosphazenverbindung enthält, die Verwendung von cyclischen Phosphazenverbindungen in organischen Leuchtdioden sowie eine Vorrichtung ausgewählt aus der Gruppe bestehend aus stationären Bildschirmen, mobilen Bildschirmen und Beleuchtungseinheiten enthaltend mindestens eine erfindungsgemäße organische Leuchtdiode und ausgewählte cyclische Phosphazenverbindungen und Verfahren zu deren Herstellung.

In der WO 2012 175219 A1 wird eine elektronische Vorrichtung offenbart, welche eine Verbindung A-B umfasst, mit
B = 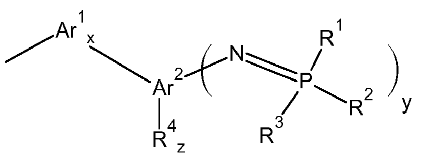 und A = -H, 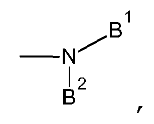 oder B³ worin - Ar¹ ein C6-C18-Arylen, welches ein- oder mehrkernig und gegebenenfalls durch eine oder mehrere C1-C10-Alkyl oder C3-C10-Cycloalkylgruppen substituiert sein kann, - Ar² ein C6-C18-Aren Skelett, welches gegebenenfalls mit elektronenabgebenden Gruppen R⁴ substituiert ist, - B¹ und B² unabhängig ausgewählt sind aus B und Ar², -B³ unabhängig ausgewählt ist aus der gleichen Gruppe wie B, - R¹, R², R³ unabhängig ausgewählt sind aus Alkyl, Arylalkyl, Cycloalkyl, Aryl, Dialkylamino, -X ausgewählt ist aus 0, 1, 2 und 3, wobei für x> 1 jedes Ar1 verschieden sein kann, - y eine nicht Null verschiedene ganze Zahl bis zu der Gesamtzahl von Valenzstellen auf dem Aren-Skelett, - z eine ganze Zahl von Null bis zur Gesamtzahl von Valenzstellen auf dem Aren-Skelett minus y sowie einer entsprechenden Verbindung gemäß Formel AB.

Verbindungen mit Aminophosphazen-Gruppen zu unterschiedlichsten Einsatzzwecken werden beispielsweise in der JP H05 12990 A, der Chemical Abstract Datenbank zu TAKEDA, TOSHIHIKO et al: "Fabrication of metal/insulator/metal electron emitter", Database accession no. 1993:572374; in HARASHINA, HATSUHIKO et al: "Odorless stable polyacetals, their manufacture including heat treatment, their compositions, and their moldings", Database accession no. 20081185532; in CHEMICAL COMMUNICATIONS - CHEMCOM; [6015D], ROYAL SOCIETY OF CHEMISTRY, GB, Nr. 5, 1. Januar 2000 (2000-01-01), Seiten 341-342, XP002444815 von LAWSON GAVIN et al und in JAMIE F. BICKLEY et al: "Supramolecular variations on a molecular theme: the structural diversity of phosphazenes (RNH)6P3N3 in the solid state", DALTON TRANSACTIONS: THE INTERNATIONAL JOURNAL FOR INORGANIC, ORGANOMETALLIC AND BIOINORGANIC CHEMISTRY, Nr. 7, 24. März 2003 (2003-03-24), Seiten 1235-1244, XP055251765 beschrieben.

Ein Verfahren zur Abscheidung von Hexaphenylsubstituierten 1,3,5,2,4,6-Triazatriphosphorinen als Dotiermaterial in organisch elektronischen Schichten zum Aufbau von OLEDs wird berichtet durch P. Schrögel et al. in Chemistry of Materials 2011, 23, 4947-4953.

Die Verwendung speziell substituierter Aminophosphazene als n-Dotanden zur Erhöhung der Leitfähigkeit organischer Elektronenleiter und nicht als Elektronenleiter selbst, ist hingegen durch den Stand der Technik nicht nahe gelegt.

Es ist daher die Aufgabe der vorliegenden Erfindung eine Substanzklasse bereitzustellen, welche in der Lage ist, durch Dotierung organischer Elektronenleiter deren Leitfähigkeit signifikant zu erhöhen. Zudem ist es die Aufgabe dieser Erfindung ein Verfahren bereitzustellen, durch welches n-Transportschichten erhältlich sind, welche eine verbesserte Leitfähigkeit aufweisen, sowie die Bereitstellung organisch elektrischer Bauelemente aufweisend diese Transportschichten.

Gelöst wird diese Aufgabe durch die Merkmale des Anspruchs 1. Besondere Ausführungsformen der Erfindung werden in den Unteransprüchen wiedergegeben.

Erfindungsgemäß ist der n-Dotierstoff zur Dotierung organischer Elektronentransportmaterialien dadurch gekennzeichnet, dass der n-Dotierstoff mindestens eine Aminophosphazen-Gruppe nach Formel 1 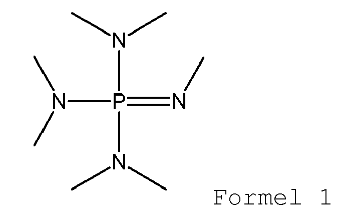 mit 4 an ein Phosphor-Atom gebundenen Stickstoffen aufweist. Es hat sich überraschenderweise gezeigt, dass insbesondere n-Dotierstoffe, welche eine Aminophosphazen-Gruppe nach der Formel 1 aufweisen, in der Lage sind, die Elektronenleitfähigkeit organischer Elektronentransportmaterialien signifikant zu erhöhen. Dieser Effekt ist dabei nicht auf die intrinsische Leitfähigkeit des erfindungsgemäßen n-Dotanden zurückzuführen, sondern ergibt sich aufgrund der Wechselwirkung des erfindungsgemäßen n-Dotanden mit einem Elektronentransportmaterial. Diese signifikante Erhöhung der Leitfähigkeit lässt sich dabei sowohl mit Substanzen erhalten, welche als funktionelle Einheiten nur Aminophosphazen-Gruppen aufweisen als auch mit Substanzen, in denen die Aminophosphazen-Gruppe nur einen Bestandteil der funktionellen Gruppen des Moleküls darstellt. Ohne durch die Theorie gebunden zu sein, ergibt sich die verbesserte Eignung zur Erhöhung der Elektronenleitfähigkeit aufgrund der Tatsache, dass die hier beanspruchte funktionelle Aminophosphazen-Einheit durch die 4 an das Phosphor gebundenen Stickstoffe besonders elektronenreich ist. Daraus folgt eine außergewöhnliche Basizität dieser Aminophosphazen-Gruppe, welche eine besonders gute Wechselwirkung mit organischen Elektronentransportmaterialien ermöglicht und derart zu einem besonders guten Dotierungsergebnis führt. Dies im Gegensatz zu Phosphazen-Verbindungen welche nicht 4 an das Phosphoratom gebundene Stickstoffe aufweisen. Diese Verbindungen zeigen nämlich eine verringerte Basizität und sind demzufolge als n-Dotierstoffe weniger geeignet. Zusätzlich erweisen sich die erfindungsgemäßen Aminophosphazene im Rahmen ihres Einsatzes in der organischen Elektronik als chemisch sehr stabil, kinetisch aktiv und vielseitig einsetzbar. Ein möglicher Mechanismus zur Erhöhung der Leitfähigkeit ergibt sich nach unten stehendem Schema:

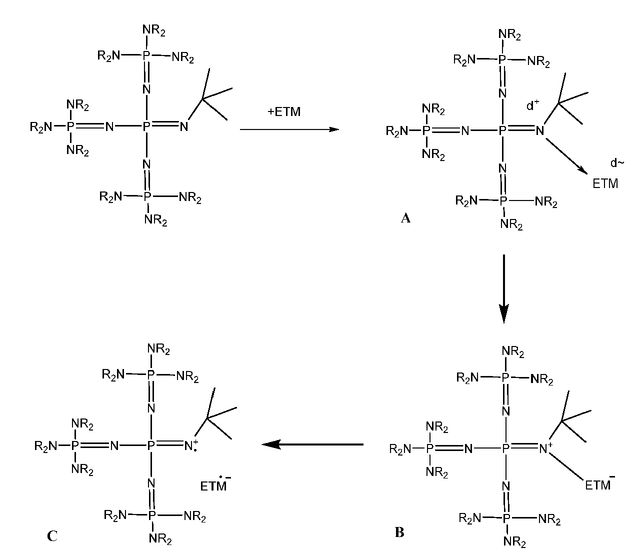

Es gibt verschiedene denkbare Dotiermechanismen. Zu einen kann es zu einer Assoziation des Dotierstoffs mit dem Elektronentransportmaterial (ETM) kommen, wodurch ein "Charge-Transfer Komplex" ausgebildet wird (Struktur A). Dieser weist neue Grenzorbitale (HOMO oder SOMO und LUMO) auf, deren energetische Lagen eine gute Wechselwirkung (z.B. hopping eines Elektrons vom "Charge-Transfer Komplex" auf ein Matrixmolekül) mit undotierten Matrixmolekülen ermöglicht, wodurch eine erhöhte Leitfähigkeit erreicht wird. Andererseits kann es durch Übertragung einer ganzen Ladung vom Dotierstoff auf die Matrix zu einer Erhöhung deren Elektronendichte und damit auch deren Leitfähigkeit kommen (Struktur B). Hierbei kann das ETM Molekül auch wieder vom Dotanden dissoziieren, wodurch sich ein Radikal-Anion der Matrix und ein Radikal-Kation des Phosphazen-Dotanden ausbilden (Struktur C). Durch die spezielle Struktur der Aminophosphazen-Gruppe erhält man eine resonanzstabilisierte Verbindung, welches für die schnelle Kinetik und gute Dotierung ursächlich sein kann.

Unter einer Aminophosphazen-Gruppe im Sinne der Erfindung wird eine Verbindung verstanden, welche mindestens eine Aminophosphazen-Gruppe nach der Formel 1 im Molekül aufweist. Dabei kann es sich um ein ungeladenes Molekül oder aber auch um eine Salzverbindung handeln, welche Ionen aufweist, wobei mindestens ein Ion eine Aminophosphazen-Gruppe umfasst. Signifikant für die Aminophosphazen-Gruppe ist die Anbindung von 4 Stickstoffen an das zentrale Phosphor-Atom. Diese zentrale Einheit kann sich im Dotierstoff wiederholen und zudem können auch mehrere Aminophosphazen-Gruppen linear oder zyklisch miteinander verbunden sein. Des Weiteren ist es aber auch möglich, dass der erfindungsgemäße Dotierstoff neben den Aminophosphazen-Einheiten auch weitere funktionelle Gruppen aufweist.

Erfindungsgemäß werden die Substanzen mit mindestens einer Aminophosphazen-Gruppe als n-Dotierstoff eingesetzt. Dies bedeutet insbesondere, dass es nicht erfindungsgemäß ist, dass diese Substanzen alleine innerhalb einer Schicht in einem organisch elektronischen Bauteil eingesetzt werden. Dies deshalb nicht, da die Grundleitfähigkeit dieser Verbindungsklasse für effektive organisch elektronische Bauteile unzureichend ist. Dieser Dotierstoff ist also zur Wechselwirkung mit einem Elektronentransportmaterial bestimmt. Hier hat sich insbesondere gezeigt, dass anscheinend die HOMO-Level der erfindungsgemäßen n-Dotanden derart ausgebildet sind, dass diese effektiv mit den LUMO-Level der gängigen Elektronentransportmaterialien in Wechselwirkung treten können. Unter Dotierstoff in diesem Zusammenhang wird also ein Stoff verstanden, welcher zusammen mit dem Elektronentransportmaterial, nach dem Fachmann bekannten Herstellungsverfahren, zusammen abgeschieden wird. Dabei ist es insbesondere bevorzugt, dass der molare Anteil des n-Dotierstoffes in der Schicht nicht oberhalb des molaren Anteils des Elektronentransportmaterials liegt. Üblicherweise ist die Konzentration des erfindungsgemäßen n-Dotierstoffes in einer Schicht deutlich geringer als der des Elektronentransportmaterials. Der erfindungsgemäße n-Dotierstoff zeigt zudem als Einzelsubstanz in einer Schicht abgeschieden, eine deutlich geringere elektrische Leitfähigkeit als Schichten aus Elektronentransportmaterialien. Durch das gemeinsame Abscheiden wird die maximale Leitfähigkeit der Elektronentransportmaterialien signifikant erhöht und zudem ergibt sich bei kleineren Spannungen schon ein deutlich höherer Stromfluss. Weiterhin ergibt sich die Funktion als n-Dotand daraus, dass in p-leitenden Schichten die erfindungsgemäßen n-Dotanden als Blockiermaterial wirken. Dies auch in Abgrenzung zu Elektronentransportmaterialien.

In einer weiteren Ausführungsform kann der n-Dotierstoff folgender Formel 2 entsprechen, 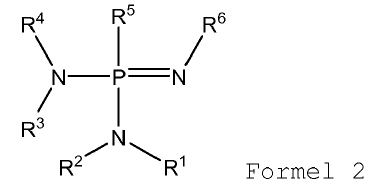 wobei
R¹ bis R⁴ unabhängig voneinander ausgewählt sind aus der Gruppe der R umfassend eine Bindung, H, D, C1-C60 gesättigtes oder ungesättigtes Alkyl, Cycloalkyl, Heteroalkyl, Heterocycloalkyl; C1-C60 Aryl, Alkylaryl, Heteroaryl; und R⁵ ausgewählt ist aus NR₂ und [-N=P(NR₂)₂-]ₙ, mit n = 1 bis 5; und
R⁶ ausgewählt ist aus der Gruppe R und [-P(NR₂)₂=N-]ₙ mit n = 1 bis 5, wobei die Substituenten unabhängig voneinander zu zyklischen Einheiten verbunden sein können. N-Dotierstoffe mit oben angegebenem Substitutionsmuster haben sich für die Dotierung von Elektronentransportmaterialien als besonders geeignet erwiesen. Ohne durch die Theorie gebunden zu sein kann dies darauf zurückgeführt werden, dass die angegebenen Substituenten die Basizität der Verbindung deutlich erhöhen, so dass sich in Verbindung mit Elektronentransportmaterialien eine verbesserte Dotierung ergibt. Des Weiteren führt die angegebene Substitution der Aminophosphazen-Gruppe dazu, dass ein sterisch geeignetes Molekül erhalten wird, welches sowohl gut in Nass- und Trockenprozessen verarbeitbar ist und anschließend in Verbindung mit den Elektronentransportmaterialien wenig zur Kristallisation neigt. Dies kann dazu führen, dass Bauelemente enthaltend Schichten dieser Substanzen eine deutlich längere Lebensdauer aufweisen können. Die einzelnen Substituenten, welche an die Stickstoffe der Aminophosphazen-Gruppe gebunden sind, können jeweils miteinander Ringstrukturen bilden. Beispiele dieser verbunden Substituenten sind weiter unten angegeben. Des Weiteren ist erfindungsgemäß, dass eine oder mehrere Aminophosphazen-Einheiten über [-P(NR₂)₂=N-]ₙ Einheiten zu ringförmigen Strukturen zusammengeschlossen sein können. Insbesondere diese ringförmigen Strukturen können dazu beitragen, dass im Rahmen der Dotierung auftretende Ladungen über den gesamten inneren Ringen verteilt werden können. Dieses kann zu einer besonders stabilen und effektiven Dotierung beitragen. Die weitere Substitution der Stickstoffe in der Formel[-P(NR₂)₂=N-]ₙ hängt davon ab, ob sich noch weitere funktionale Gruppen anschließen oder es sich um eine terminale Gruppe handelt. Beispiele dieser Verbindungen mit mehreren Aminophosphazen-Einheiten, welche mehrere Aminophosphazen-Gruppen tragen sind weiter unten angegeben.

In einer zusätzlichen Charakteristik des n-Dotierstoffes können die Substituenten R¹ - R⁴ unabhängig voneinander ausgesucht sein aus der Gruppe R' umfassend eine Bindung, C1-C20 substituierte oder nicht-substituierte Alkyl, Cycloalkyl; R⁵ ist ausgewählt aus NR'₂ und [-N=P(NR'₂)₂-]ₙ mit n = 1 bis 5; und R⁶ ist ausgewählt ist aus der Gruppe R' und [-P(NR'₂)₂=N-]ₙ mit n = 1 bis 5, wobei die Substituenten unabhängig voneinander zu zyklischen Einheiten verbunden sein können. Gerade die kurz- bis mittelkettigen Alkyl- und Cycloalkyl-Substituenten führen zu einer besonders guten Eignung des n-Dotierstoffes zur Erhöhung der Leitfähigkeit von Elektronentransportmaterialien. Ohne durch die Theorie gebunden zu sein ergibt sich dies hochwahrscheinlich durch den induktiven Effekt dieser Substituenten, welcher zu einer erhöhten Basizität der funktionalen Gruppe führt. Anscheinend sind diese Substituenten zudem sterisch derart ausgebildet, dass es zu einer sehr schnellen und effektiven Wechselwirkung mit Elektronentransportmaterialien kommt.

In einer weiteren erfindungsgemäßen Ausgestaltung kann die Schichtdickenkonzentration (Volumen-%) des n-Dotierstoffs in einer Schicht ≥ 0,01 % und ≤ 30 % betragen. Innerhalb dieses Konzentrationsbereiches lässt sich mit dem erfindungsgemäßen n-Dotierstoff eine ausreichende Erhöhung der n-Leitfähigkeit von Elektronentransportschichten erreichen. Höhere Konzentrationen an n-Dotierstoff sind weniger bevorzugt, da dies zu einer Reduzierung der Leitfähigkeit der Schichten führen kann. Dies kann darauf zurückgeführt werden, dass der Anteil an Elektronenleiter in der Schicht zu gering wird. Wie schon oben erwähnt, eignen sich die erfindungsgemäßen Aminophosphazene insbesondere als n-Dotierstoff und nicht als Elektronentransportmaterial. In einer weiteren Ausführungsform der Erfindung kann die molare Konzentration des n-Dotierstoffes in einer Schicht ≥ 0,1 % und ≤ 25 % bevorzugt ≥ 1 % und ≤ 20 % betragen. Die quantitative Bestimmung der molaren Anteile an Substanzen innerhalb einer Schicht ist dabei dem Fachmann bekannt. So können die Schichten beispielsweise aufgelöst und mittels gängiger quantitativer Bestimmungsmethoden, wie zum Beispiel der HPLC, ermittelt werden.

Weiterhin kann in einem zusätzlichen Aspekt der Erfindung die Anzahl der Aminophosphazen-Gruppen im Dotierstoff ≥ 2 und ≤ 7 betragen. Aufgrund der Basizität der erfindungsgemäß einsetzbaren Aminophosphazen-Gruppen und der darauf beruhenden Wechselwirkung mit dem Elektronentransportmaterial, kann es von Vorteil sein, dass der eingesetzte Dotierstoff eine höhere Anzahl an Aminophosphazen-Gruppen trägt. Ohne durch die Theorie gebunden zu sein, ist der Dotierstoff dadurch in der Lage, mit mehreren Molekülen des Matrixmaterials zu wechselwirken oder gegebenenfalls mehrere Ladungen auf das Matrixmaterial zu übertragen. Dies kann zu einer Erhöhung der Leitfähigkeit der Schicht beitragen. Des Weiteren kann durch die Wechselwirkungen mit mehreren Matrixmolekülen erreicht werden, dass die Kristallisationsneigung der Schicht abnimmt. Dies kann zu einer verlängerten Haltbarkeit von Bauelementen aufweisend diese Schichten beitragen.

In einer bevorzugten Ausführungsform kann der Dotierstoff eine Verbindung mit nicht-zyklischem Aminophosphazen-Grundgerüst sein. Gerade die linearen Dotierstoffe, welche mindestens eine Aminophosphazen-Gruppe aufweisen, haben sich zur Dotierung organischer Elektronentransportmaterialien als besonders geeignet erwiesen. Ohne durch die Theorie gebunden zu sein, kann dies hochwahrscheinlich darauf zurückgeführt werden, dass die sterischen Eigenschaften dieser Substanzklasse eine besonders gute Annäherung an die Elektronentransportmaterialien ermöglicht, welches dann anschließend zu einem sehr schnellen und effizienten Ladungstransfer führen kann. Zusätzlich kann die lineare Geometrie der n-Dotanden dazu führen, dass aufgrund der verringerten Kristallisationsneigung eine erhöhte Lebensdauer organischer Bauelemente enthaltend diese Substanzklasse erreicht wird.

In einer besonders bevorzugten Ausführungsform der Erfindung kann der Dotierstoff mindestens eine Verbindung der folgenden Formeln 3-28 umfassen: 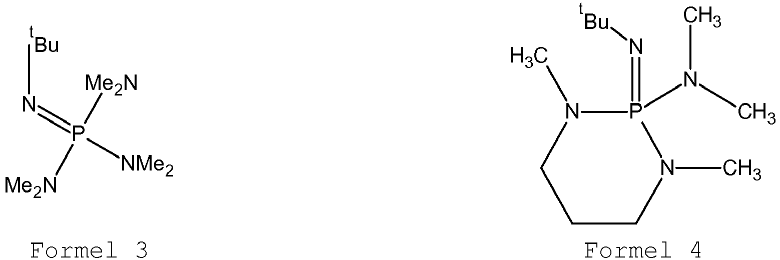 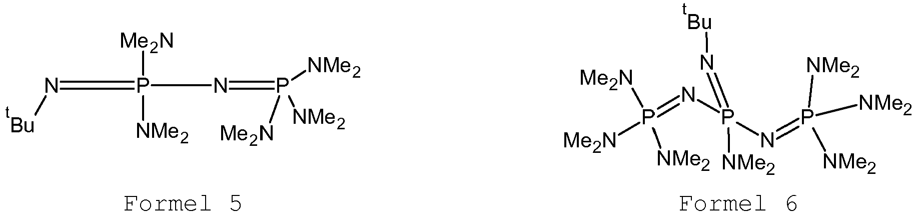 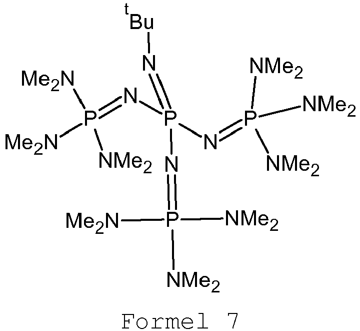 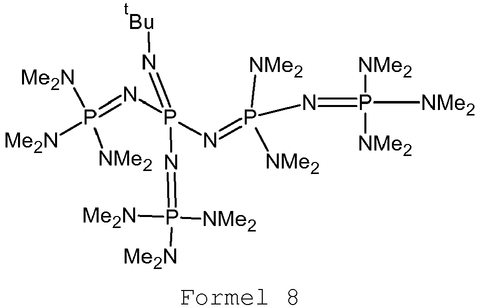 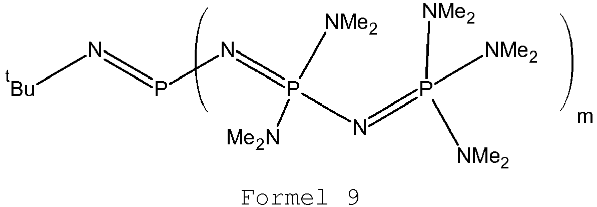 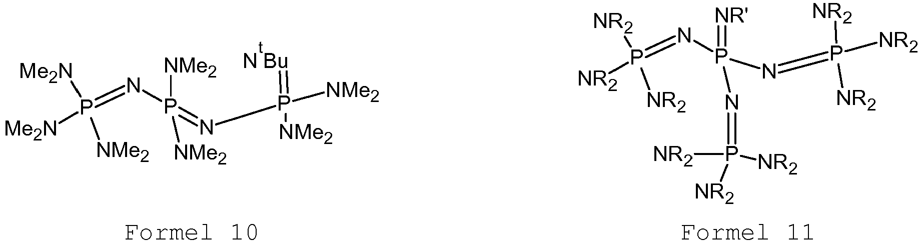 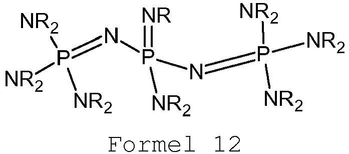 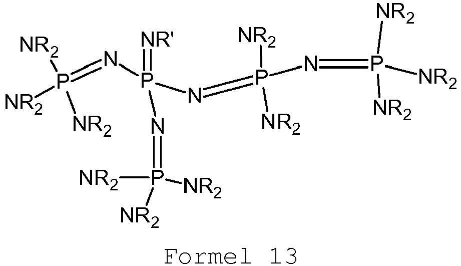 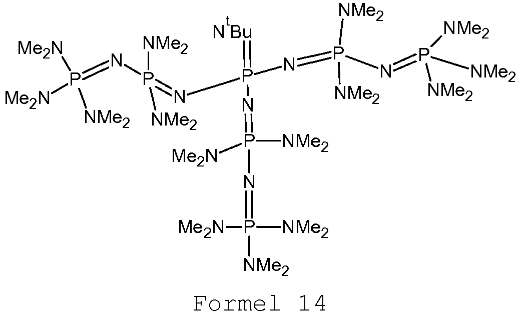 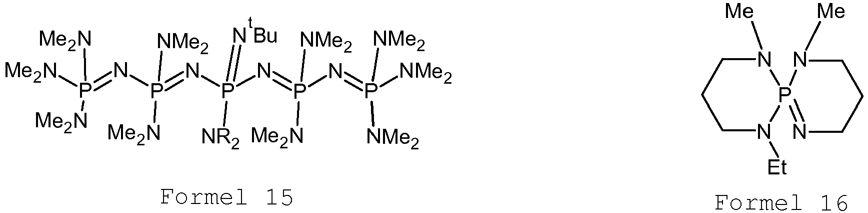 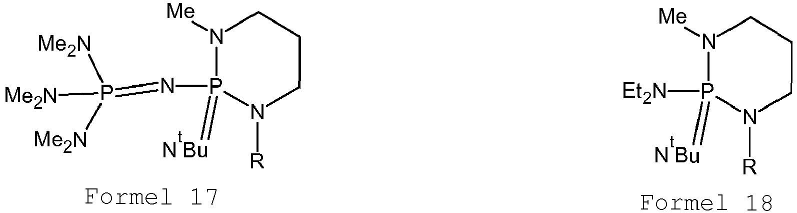 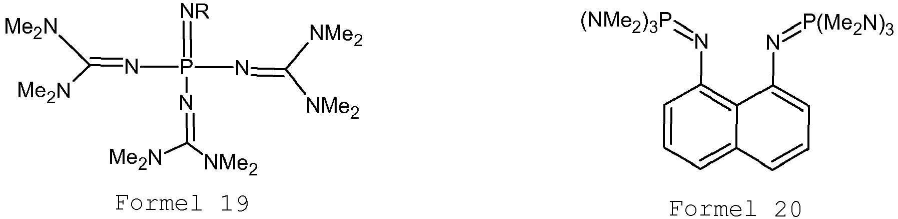 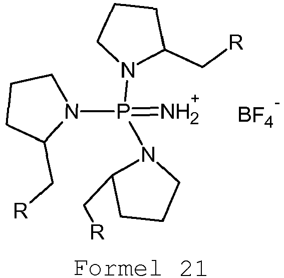 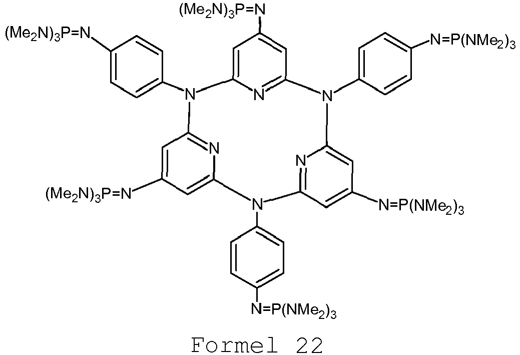 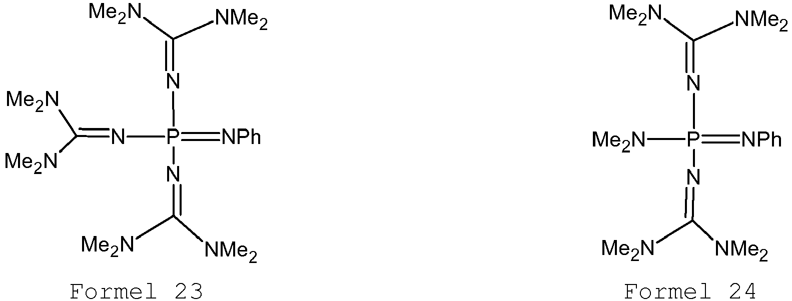 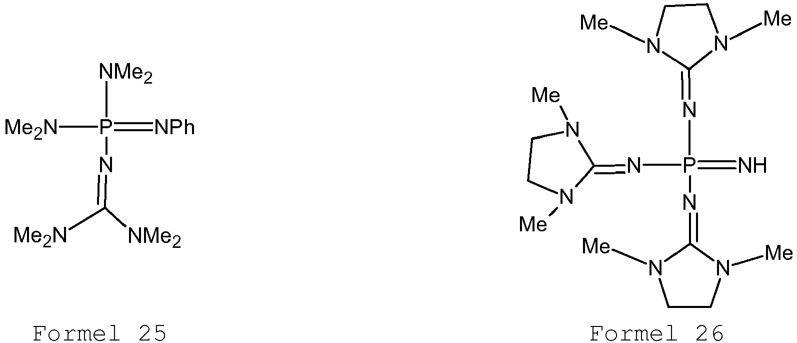 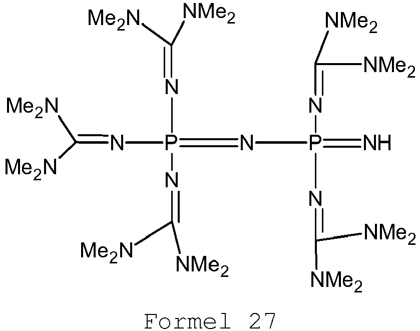 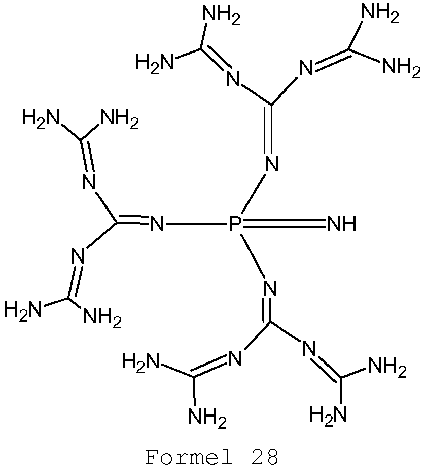 wobei m in Formel 9 ≥ 1 und ≤ 5. Es hat sich gezeigt, dass die Verbindungen nach den Formeln 3-28 sich für die Dotierung herkömmlicher Elektronentransportmaterialien besonders eignen. Insbesondere ist das Substituentenmuster dieser Dotierstoffe in der Lage, Verbindungen bereitzustellen, welche sich sowohl über Nass- wie auch Trockenprozesse verarbeiten lassen. Die räumlichen Eigenschaften der gewählten Substituenten scheinen zudem sehr geeignet, zusammen mit organischen Elektronentransportmaterialien Schichten zu bilden, welche sich durch besonders geringe Kristallisationsneigung auszeichnen. Dies kann zu einer längeren Lebensdauer organisch elektronischer Bauelemente führen.

Weiterhin im Sinne der Erfindung ist ein n-Dotierstoff, wobei ≥ 1 und ≤ 4 Substituenten der R¹ - R⁴ und R⁶ tert-butyl-Substituenten (^{t}Bu) sind. Insbesondere die Aminophosphazen-Verbindungen in welchen tertiäre-Butylgruppen an die Stickstoffe gebunden sind zeichnen sich durch einen besonders guten Dotiereffekt aus. Ohne durch die Theorie gebunden zu sein, kann dies darin begründet liegen, dass die tertiären-Butylgruppen sowohl geeignete induktive Eigenschaften als auch eine geeignete sterische Ausgestaltung aufweisen, welche in der Lage ist, sowohl die Basizität der Verbindung zu erhöhen als auch einen einfachen Zutritt der Matrixmaterialien zum Dotierstoff zu ermöglichen. Eine höhere Anzahl an tertiären Butylgruppen kann weniger vorteilhaft sein, da in diesem Fall ein Zutritt des Matrixmaterials erschwert werden kann.

Ebenfalls offenbart hierin wird ein Dotierstoff, der eine cyclische Struktur mit zwei bis vier verknüpften Aminophosphazen-Einheiten aufweist. Gerade die zyklischen Strukturen der Aminophosphazene können in der Lage sein, eine besonders effektive Dotierung von Elektronentransportmaterialien zu erreichen. Dies hochwahrscheinlich dadurch, dass die Basizität der Verbindung durch zyklische Anordnung noch verstärkt wird. Des Weiteren können die nach der Dotierung auftretenden Ladungen effektiv über das gesamte Ringsystem verteilt werden. Als Funktion der Anzahl der verknüpften Aminophosphazen-Einheiten ergeben sich demnach bei der Verknüpfung von 2 Einheiten ein 4-Ring, bei der Verknüpfung von 3 Einheiten ein 6-Ring und bei der Verknüpfung von 4 Einheiten ein 8-Ring. Diese Ringgröße ermöglicht zudem eine gute Verarbeitung der Verbindungen sowohl in Nassprozessen wie auch bei der Vakuumabscheidung. Größere Ringgerüste können hingegen nachteilig sein, da in diesen Fällen eine effektive Verdampfung der Substanzen gehindert sein kann.

In einem zusätzlichen Aspekt der Offenbarung kann mindestens einer der Substituenten an jedem nicht Ring-Stickstoff ein über ein Kohlenstoff gebundener C1-C60 Alkyl-, Cycloalkyl-, Aryl- oder Heteroarylrest sein, wobei die einzelnen Substituenten miteinander verbunden sein können. Es hat sich gezeigt, dass insbesondere die Substitution der nicht Ring-Stickstoffe durch oben angegebenes Substitutionsmuster eine besonders geeignete Erhöhung der Basizität der Aminophosphazen-Verbindungen ermöglicht, ohne einen negativen Einfluss auf die Kinetik einer späteren Umsetzungsreaktion mit Elektronentransportmaterialien zu verursachen. Aus diesem Grund ist es also vorteilhaft, dass mindestens einer der Substituenten an den nicht Ring-Stickstoffen mit einem der oben angegebenen Substituenten besetzt ist.

In einer speziellen Ausführungsform der Offenbarung kann jeder der Substituenten an jedem nicht Ring-Stickstoff ein über ein Kohlenstoff gebundener C1-C30 Alkyl-, Cycloalkyl-, Aryl- oder Heteroarylrest sein, wobei die einzelnen Substituenten miteinander verbunden sein können. Anscheinend bedingt durch die elektronischen Eigenschaften der oben angegebenen Substituenten ergeben sich, wahrscheinlich aufgrund der induktiven Effekte, besonders effektive n-Dotierstoffe. Hierzu scheinen insbesondere die kurz- bis mittelkettigen Alkyl- und Arylverbindungen besonders geeignet. Diese Verbindungen lassen sich einfach sowohl in Nass- wie auch in Vakuumprozessen verarbeiten und liefern langzeitstabile dotierte Schichten.

In einer besonderen Ausgestaltung der Offenbarung kann der Dotierstoff mindestens eine der folgenden Formeln 29-35 umfassen:

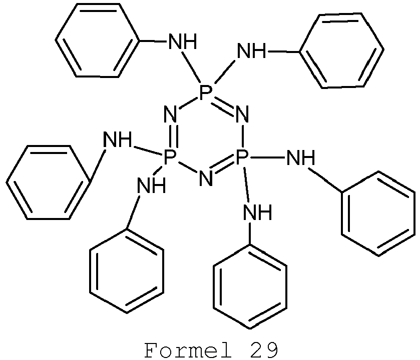

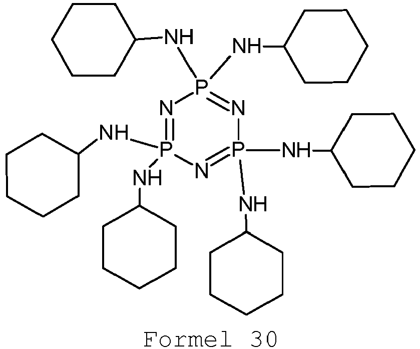

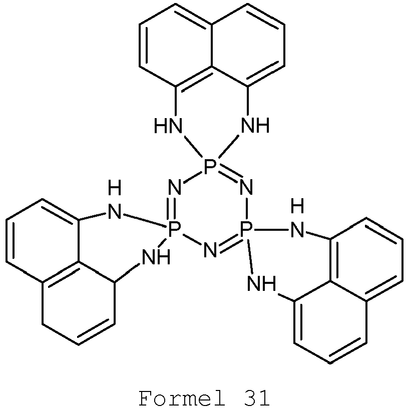

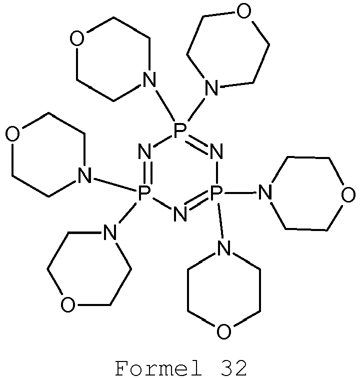

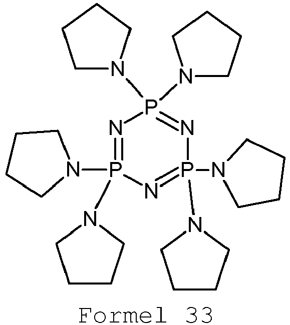

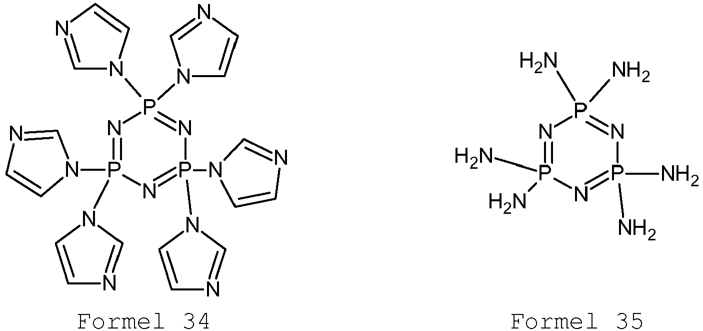

Die zyklischen Verbindungen der Formeln 29-35 scheinen aufgrund ihrer sterischen Ausgestaltung und den durch das Substituenten-Muster vorgegebenen elektrischen Eigenschaften besonders zur n-Dotierung von Elektronentransportschichten geeignet zu sein. Die molekulare Masse dieser Verbindungen ermöglicht zudem eine gute Verarbeitung in Vakuumprozessen.

Erfindungsgemäss ist also ein Verfahren zur Herstellung n-leitender organisch elektrischer Schichten, wobei der organische n-Dotierstoff zusammen mit einem organischen Elektronentransportmaterial innerhalb einer Schicht abgeschieden und der n-Dotierstoff und das Elektronentransportmaterial zur Reaktion gebracht werden. Ohne durch die Theorie gebunden zu sein, kann dabei das zur Reaktion bringen nach dem weiter oben angegebenen Reaktionsmechanismus stattfinden. Es kann also erst eine elektrostatische Wechselwirkung des erfindungsgemäßen n-Dotanden mit dem Elektronentransportmaterial erfolgen, welches anschließend zu einer Übertragung von Elektronen auf das Elektronentransportmaterial führen kann. Dabei kann das zur Reaktion bringen aufgrund einer geeigneten Reaktionskinetik automatisch durch das gleichzeitige Abscheiden in einer Schicht erfolgen. Je nach gewähltem Elektronentransportmaterial und eingesetztem n-Dotand kann das zur Reaktion bringen auch über eine anschließende thermische Anregung erfolgen. Für dieses Verfahren lassen sich die gängigen Elektronentransportmaterialien einsetzen, welche dem Fachmann im Rahmen der organischen Elektronik geläufig sind. Das Abscheiden beider Materialien kann dabei sowohl aus der Nassphase wie auch durch einen Vakuumprozess erfolgen. Das Aminophosphazen dient dabei als n-Dotand und kann entweder durch Co-Verdampfen mit einem Elektronentransportmaterial oder durch Mischen eines Aminophosphazens mit einem ETM und anschließendem Flüssigprozessieren (z.B. Spin Coating, Inkjet Printing, Slot Coating etc.) seine Dotierwirkung entfalten. Aufgrund der guten Löslichkeit auch in sehr unpolaren Lösungsmitteln sind die Aminophosphazen-Basen sehr gut für die Flüssigprozessierung geeignet. Die größeren Moleküle (z.B. eine P4 Base) sind thermisch sehr stabil und können im Hochvakuum im gewünschten Temperaturbereich unzersetzt verdampft werden, wodurch sie für die Vakuumprozessierung geeignet sind.

In einer besonderen Ausführungsform des Verfahrens kann das organische Elektronentransportmaterial ausgesucht sein aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphin oxid; 3,3',5,5'-tetra[(m-pyridyl)-phen-3-yl]biphenyl; 1,3,5-tris[(3-pyridyl)-phen-3-yl]benzol; 4,4'-bis(4,6-diphenyl-1,3,5-triazin-2-yl)biphenyl; 1,3-bis[3,5-di(pyridin-3-yl)phenyl]benzol; Diphenylbis(4-(pyridin-3-yl)phenyl)silan; 3,5-di(pyren-1-yl)pyridin; 1,3,5-tri(p-pyrid-3-ylphenyl)benzol; 2,4,6-tris(3'-(pyridin-3-yl)biphenyl-3-yl)-1,3,5-triazin; Naphtahlintetracarbonsäuredianhydrid bzw. dessen Imide; Perylentetracarbonsäuredianhydrid bzw. dessen Imide; Materialien basierend auf Silolen mit einer Silacyclopentadieneinheit. Diese Elektronentransportmaterialien lassen sich aufgrund ihrer elektronischen Eigenschaften (HOMO/LUMO-Level) gut mit den erfindungsgemäßen Aminophosphazen-Dotanden zur Reaktion bringen. Durch das zusätzliche Eindotieren der Aminophosphazene lässt sich insbesondere die Leitfähigkeit der Elektronentransportmaterialien deutlich erhöhen. Weiterhin erfindungsgemäß ist eine n-leitende organisch elektrische Schicht, welche nach dem erfindungsgemäßen Verfahren hergestellt wurde. Durch das oben vorgestellte Verfahren lassen sich insbesondere homogene Schichten erhalten, welche sich für den Einsatz in Bauelementen der organischen Elektronik eignen. Dabei sind, wie schon erwähnt, insbesondere die erfindungsgemäßen Aminophosphazene geeignet, um mit den Standardverfahren der organischen Elektronik verarbeitbar zu sein. Zudem zeichnen sich die derart hergestellten Schichten dadurch aus, dass sie eine geringe Kristallisationsneigung aufweisen, welches zu einer längeren Lebensdauer organischer Bauelemente enthaltend diese Schichten beiträgt. Die erhöhte Leitfähigkeit der Elektronentransportschichten führt zudem zu einer höheren Effizienz der Schichten.

Ebenso erfindungsgemäß ist ein organisch elektrisches Bauelement, wobei das Bauelement eine erfindungsgemäße n-leitende organisch elektrische Schicht umfasst, die nach dem beanspruchten Verfahren hergestellt wurde. Das erfindungsgemäße Verfahren zur Herstellung dotierter Elektronentransportschichten lässt sich besonders gut zur Herstellung organisch elektrischer Bauelemente nutzen. Auf diese Art und Weise werden langlebige, effiziente Bauelemente erhalten. Die organisch elektrischen Bauelemente können dabei die Standardbauelemente der organischen Elektronik umfassen, nämlich organische Photodioden, Solarzellen, Bipolar- und Feldeffekttransistoren und organische Leuchtdioden.

Hinsichtlich weiterer Vorteile und Merkmale des vorbeschriebenen Verfahrens wird hiermit explizit auf die Erläuterungen im Zusammenhang mit dem erfindungsgemäßen organischen n-Dotanden, den erfindungsgemäßen Schichten sowie den erfindungsgemäßen Bauelementen verwiesen. Auch sollen erfindungsgemäße Merkmale und Vorteile der erfindungsgemäßen Schichten, das erfindungsgemäße Verfahren und die erfindungsgemäßen organischen Bauelemente anwendbar sein und als offenbart gelten und umgekehrt. Unter die Erfindung fallen auch sämtliche Kombinationen aus zumindest zwei von in der Beschreibung und/oder den Ansprüchen offenbarten Merkmalen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Die Eigenschaften der beschriebenen n-Dotierstoffe und mögliche Ausgestaltungen elektrischer Bauelemente, in denen der Dotierstoff zum Einsatz kommen kann, werden nachfolgend anhand von Figuren näher erläutert. Die Figuren zeigen
- Fig. 1: schematisch den Aufbau einer organischen Leuchtdiode (10). Die Leuchtdiode ist aufgebaut aus einer Glas-Schicht (1); Silikon- oder Indium-Zinn-Oxid (ITO)-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); Elektronen-Injektor-schicht (8)und einer Kathoden-Schicht (9);
- Fig. 2: schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
- Fig. 3: schematisch einen möglichen Querschnitt eines organischen Feld-Effekt-Transistors (30). Auf einem Substrat (31) ist eine Gate-Elektrode (32), ein Gate-Dielektrikum (33), ein Source und Drain-Kontakt (34 + 35) und ein organischer Halbleiter (36) aufgebracht. Die schraffierten Stellen zeigen die Stellen an denen eine Kontaktdotierung hilfreich ist.
- Fig. 4: eine IV-Kennlinie eines elektronenleitenden Matrix-materials (ETM036, Merck), welcher mit einem erfindungsgemäßen n-Dotanden (P4-tBu) dotiert wurde. Die Kennlinien werden bei den Beispielen diskutiert.
- Fig. 5: eine IV-Kennlinie eines weiteren elektronenleitenden Matrixmaterials (ETM019, Merck), welcher mit einem erfindungsgemäßen n-Dotanden (P4-tBu) dotiert wurde. Die Kennlinien werden bei den Beispielen diskutiert.
- Fig. 6: eine IV-Kennlinie eines weiteren elektronenleitenden Matrixmaterials (TMM004, Merck), welcher mit einem erfindungsgemäßen n-Dotanden (P4-tBu) dotiert wurde. Die Kennlinien werden bei den Beispielen diskutiert.
- Fig. 7: eine IV-Kennlinie eines weiteren elektronenleitenden Matrixmaterials (Alq3, Aluminium-tris(8-hydroxychinolin)), welcher mit einem erfindungsgemäßen n-Dotanden (P4-tBu) dotiert wurde. Die Kennlinien werden bei den Beispielen diskutiert.

### Beispiele:

Die erfindungsgemäße Eignung der hier beanspruchten n-Dotierstoffe wird anhand der Dotierung unterschiedlicher organischer Elektronenleiter gezeigt. Als n-Dotierstoff wird die Aminophosphazen-Base P₄-^{t}Bu 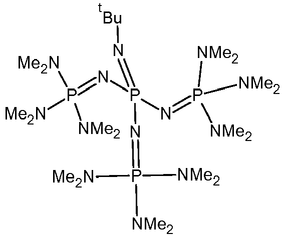 verwendet.

### I. Aufreinigung des n-Dotierstoffes

Die Phosphazen Base P₄-^{t}Bu ist bei Sigma-Aldrich kommerziell als 0,8 M Lösung in n-Hexan erhältlich. Die Lösung (1 mL) wurde in einer Glovebox in ein Schlenkrohr gefüllt und mittels Vakuum zur Trockene eingeengt. Der weiße Rückstand wurde anschließend drei Mal bei 105°C im Hochvakuum (3 - 4 x10⁻⁶ mbar) sublimiert. Das Produkt wurde in einer Ausbeute von 73% als weißer, teilweise kristalliner Feststoff erhalten.

### II. Dotierung unterschiedlicher elektronenleitender Matrixmaterialien mit einem erfindungsgemäßen n-Dotierstoff

Als Referenz zur dotierten Schicht wurde jeweils ein Majoritätsladungsträgerbauelement mit folgender Bauteilarchitektur hergestellt:
Glas Substrat
ITO (Indium-Zinn-Oxid) als Anode
200 nm elektronenleitendes Matrixmaterial
Calcium als Kathode
Aluminium als Deckschicht zum Schutz der reaktiven Ca Kathode

Es wurden Bauteile mit je 15 Pixeln und einer Pixelfläche von 4 mm² hergestellt.

Diese Referenzelemente werden jeweils mit Elementen verglichen, in denen die Schicht aus elektronenleitendem Matrixmaterial zusätzlich mit einem erfindungsgemäßen n-Dotanden (P₄-^{t}Bu) dotiert wurde.

Es wurden jeweils 4 unterschiedliche elektronenleitende Matrixmaterialien eingesetzt:
1. ETM-036, Merck
2. ETM-019, Merck
3. TMM-004, Merck
4. Alq3

Der Schichtdickenanteil (Volumen-%) an Dotierstoff beträgt in den Fällen 1. bis 3. 18 %, wohingegen bei der Dotierung von Alq3 17 % Dotierstoff eingesetzt wurden.

### III. Strom-Spannungskennlinien der unterschiedlichen Elektronentransportschichten

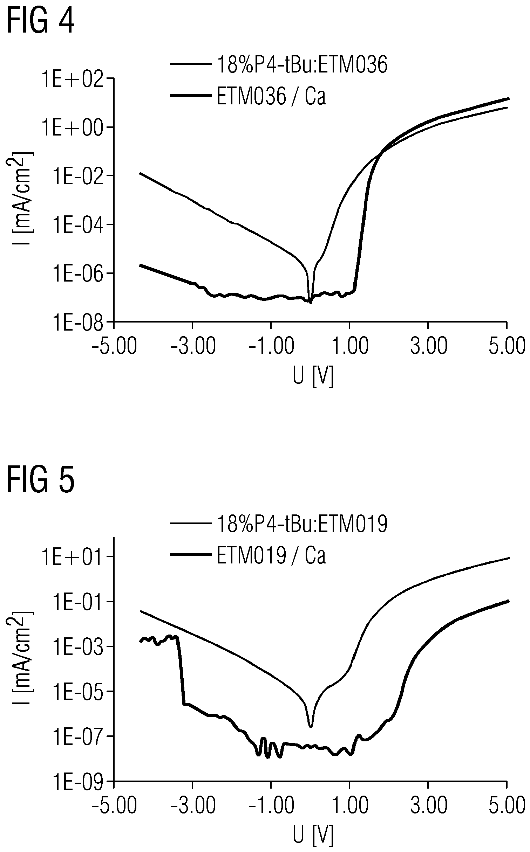

Der Vergleich der dotierten elektronenleitenden Matrixmaterialien mit den undotierten Matrixmaterialien ist in den Figuren 4-7 dargestellt.

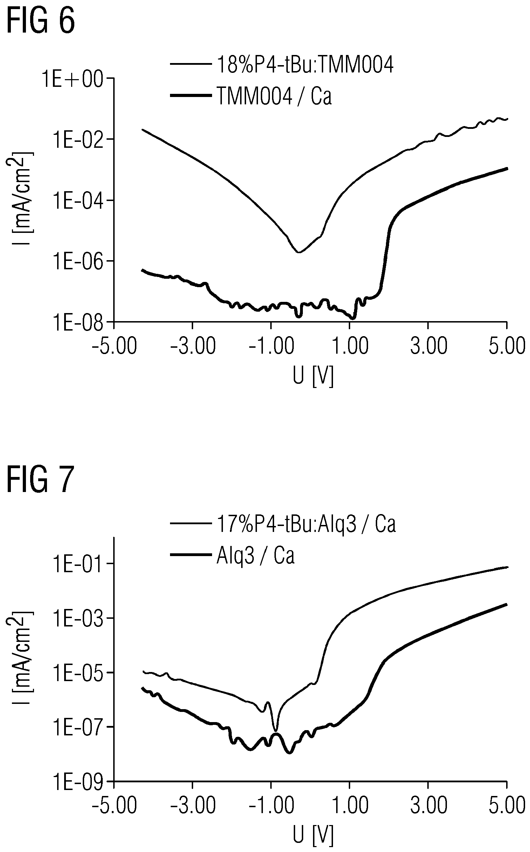

Dabei zeigt die Figur 4 die Strom-Spannungskennlinie für die Dotierung von ETM-036, die Figur 5 die Dotierung von ETM-019, die Figur 06 die Dotierung von TMM-004 und die Figur 7 die Dotierung von Alq3 jeweils mit P₄-^{t}Bu.

Es kann für alle Bauelemente gezeigt werden, dass die Stromdichte in der dotierten Schicht oberhalb und unterhalb von 0 V stark ansteigt, während für die intrinsische (undotierte) Schicht (schwarze Kennlinie) eine typische Diodenkennlinie beobachtet wird. Bei den undotierten Schichten ist eine deutliche Überspannung (built-in voltage) nötig, bevor die Stromdichte ansteigt. Außerdem ist dies bei der intrinsischen Schicht nur bei positiven Spannungen der Fall, während die dotierten Schichten auch bei negativen Spannungen erhöhte Stromdichten zeigen. Dies ermöglicht auch eine effiziente Elektroneninjektion von der Anode (ITO).

Somit zeigen alle elektronenleitenden Matrixmaterialien durch die erfindungsgemäße Dotierung eine Verbesserung im Strom-Spannungsverhalten.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Herstellung n-leitender organisch elektrischer Schichten, **dadurch gekennzeichnet, dass** ein n-Dotierstoff nach Formel 2 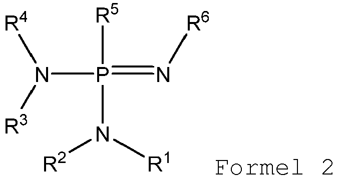 wobei
R¹ bis R⁴ unabhängig voneinander ausgewählt sind aus der Gruppe der R umfassend eine Bindung, H, D, C1-C60 gesättigtes oder ungesättigtes Alkyl, Cycloalkyl, Heteroalkyl, Heterocycloalkyl; C1-C60 Aryl, Alkylaryl, Heteroaryl;
R⁵ ausgewählt ist aus NR₂ und [-N=P(NR₂)₂-]ₙ mit n = 1 bis 5; und
R⁶ ausgewählt ist aus der Gruppe R und [-P(NR₂)₂=N-]ₙ mit n = 1 bis 5, wobei die Substituenten unabhängig voneinander zu zyklischen Einheiten verbunden sein können;
wobei der Dotierstoff eine Verbindung mit nicht-zyklischem Aminophosphazen-Grundgerüst ist;
zusammen mit einem organischen Elektronentransportmaterial innerhalb einer Schicht abgeschieden und der n-Dotierstoff und das Elektronentransportmaterial zur Reaktion gebracht werden.

2. Verfahren nach Anspruch 1, wobei die Substituenten R¹ -R⁴ unabhängig voneinander ausgesucht sind aus der Gruppe R' umfassend eine Bindung, C1-C20 substituierte oder nicht-substituierte Alkyl, Cycloalkyl;
R⁵ ausgewählt ist aus NR'₂ und [-N=P(NR'₂)₂-]ₙ mit n = 1 bis 5; und
R⁶ ausgewählt ist aus der Gruppe R' und [-P(NR'₂)₂=N-]ₙ mit n = 1 bis 5, wobei die Substituenten unabhängig voneinander zu zyklischen Einheiten verbunden sein können.

3. Verfahren nach Anspruch 1 oder 2, wobei die Schichtdickenkonzentration (Volumen-%) des n-Dotierstoffs in einer Schicht ≥ 0,01 % und ≤ 30 % beträgt.

4. Verfahren nach einem der vorhergehenden Ansprüche, wobei die Anzahl der Aminophosphazen-Gruppen im Dotierstoff ≥ 2 und ≤ 7 beträgt.

5. Verfahren nach einem der vorhergehenden Ansprüche, wobei der Dotierstoff mindestens eine Verbindung der folgenden Formeln 3-28 umfasst: 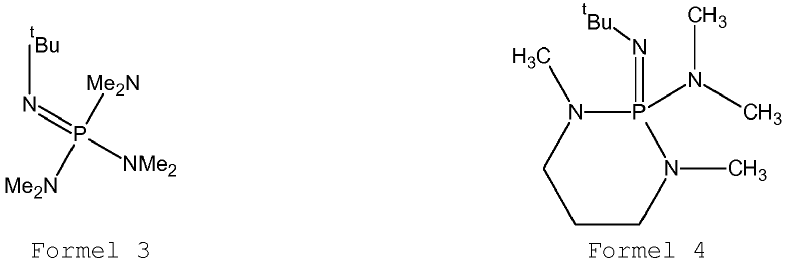 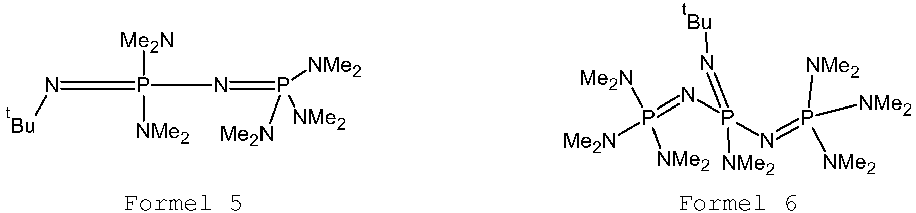 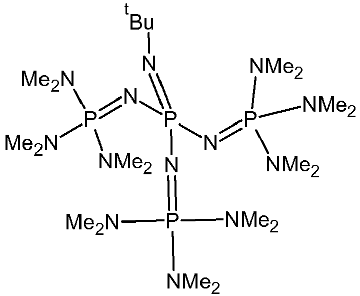 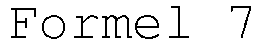 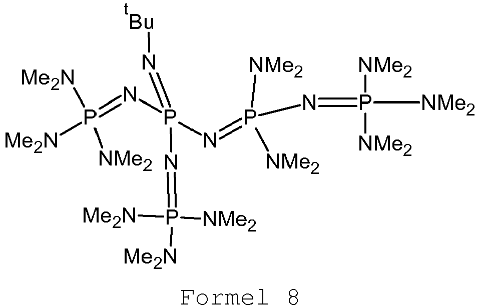 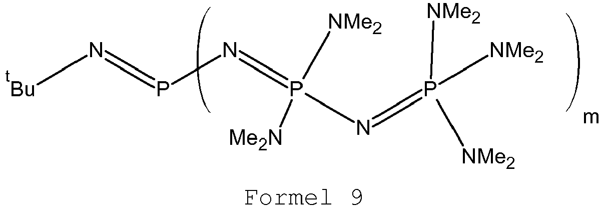 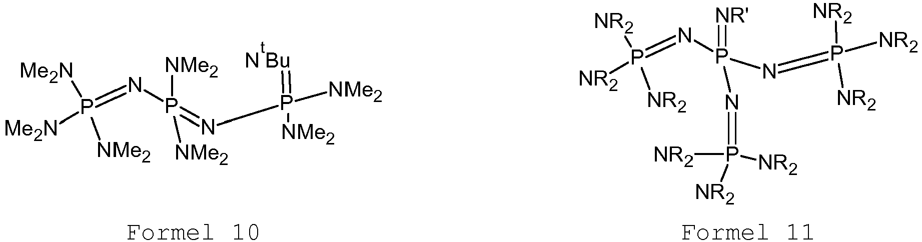 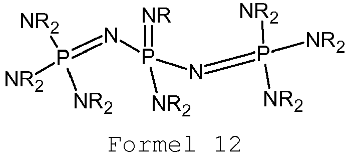 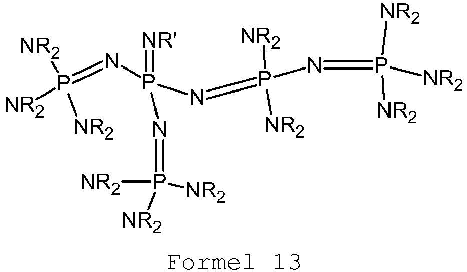 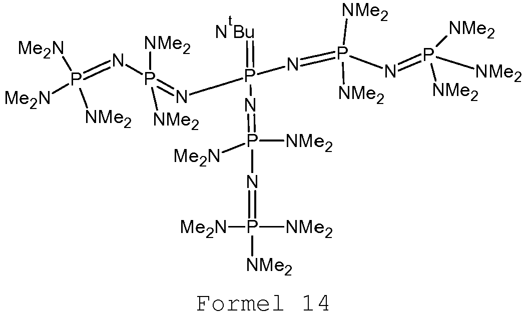 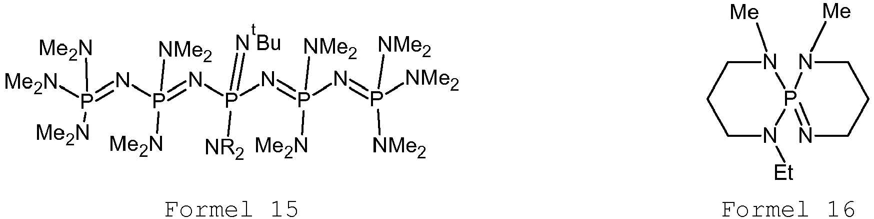 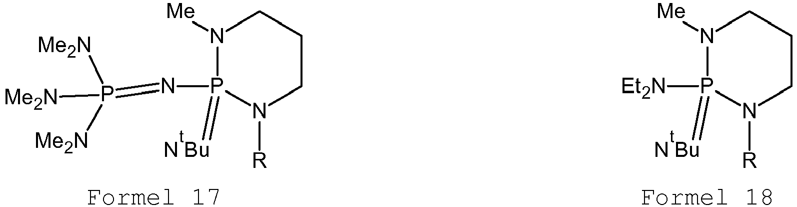 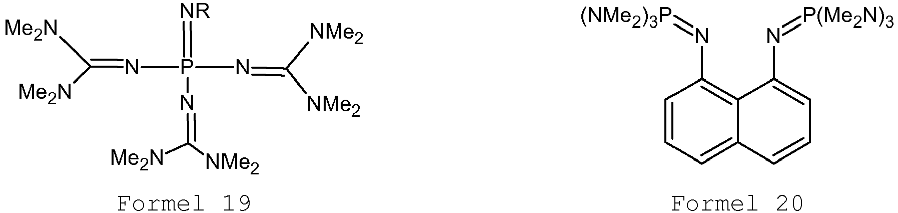 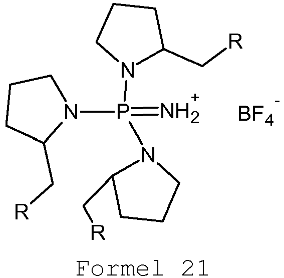 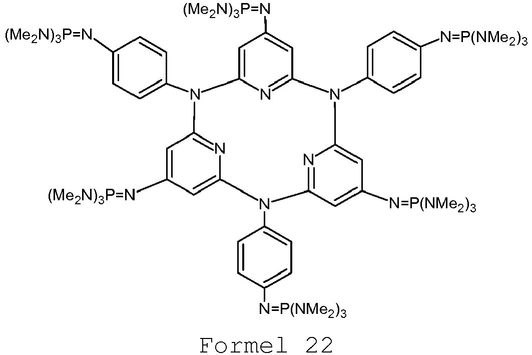 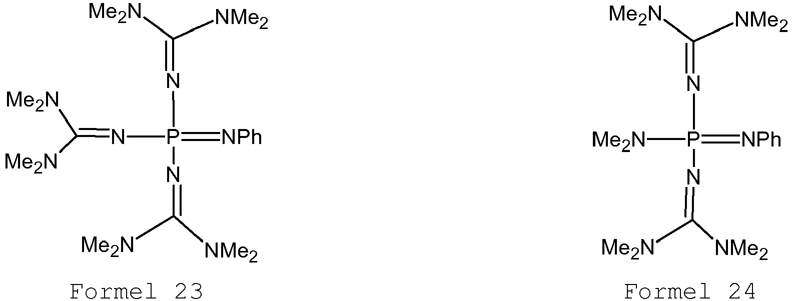 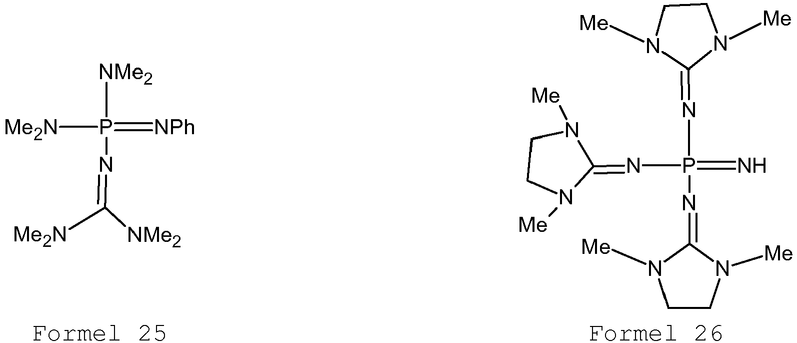 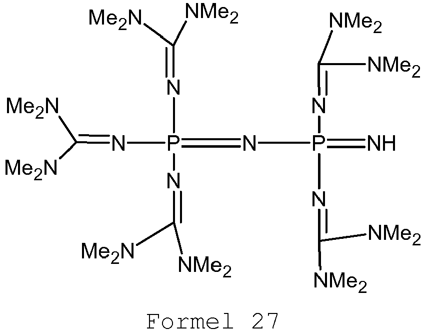 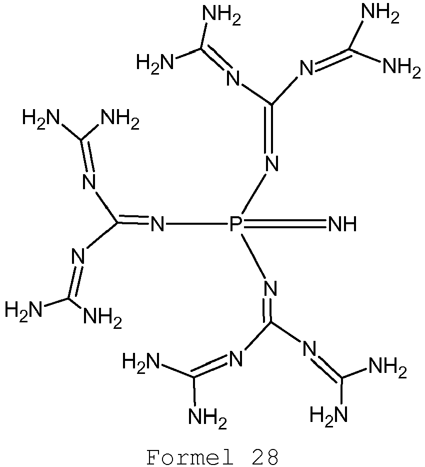 wobei m in Formel 9 ≥ 1 und ≤ 5.

6. Verfahren nach einem der vorhergehenden Ansprüche, wobei das organische Elektronentransportmaterial ausgesucht aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphin oxid; 3,3',5,5'-tetra[(m-pyridyl)-phen-3-yl]biphenyl; 1,3,5-tris[(3-pyridyl)-phen-3-yl]benzol; 4,4'-bis(4,6-diphenyl-1,3,5-triazin-2-yl)biphenyl; 1,3-bis[3,5-di(pyridin-3-yl)phenyl]benzol; Diphenylbis(4-(pyridin-3-yl)phenyl)silan; 3,5-di(pyren-1-yl)pyridin; 1,3,5-tri(p-pyrid-3-yl-phenyl)benzol; 2,4,6-tris(3'-(pyridin-3-yl)biphenyl-3-yl)-1,3,5-triazin; Naphtahlintetracarbonsäuredianhydrid bzw. dessen Imide; Perylentetracarbonsäuredianhydrid bzw. dessen Imide; Materialien basierend auf Silolen mit einer Silacyclopentadieneinheit ist.

7. N-leitende organisch elektrische Schicht, hergestellt nach einem Verfahren nach einem der Ansprüche 1 - 6.

8. Organisch elektrisches Bauelement, **dadurch gekennzeichnet, dass** das Bauelement eine n-leitende organisch elektrische Schicht nach Anspruch 7 umfasst.

## Claims

1. Method for producing n-conducting organic-electrical layers, **characterized in that** an n-dopant of formula 2 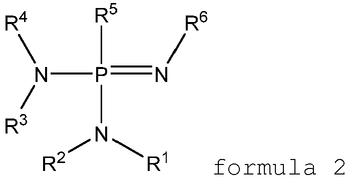 where
R¹ to R⁴ independently of one another are selected from the group of R comprising a bond, H, D, C1-C60 saturated or unsaturated alkyl, cycloalkyl, heteroalkyl, heterocycloalkyl; C1-C60 aryl, alkylaryl, heteroaryl;
R⁵ is selected from NR₂ and [-N=P(NR₂)₂-]ₙ where n = 1 to 5; and
R⁶ is selected from the group of R and [-P(NR₂)₂=N-]ₙ where n = 1 to 5, it being possible for the substituents independently of one another to be joined to form cyclic units;
wherein the dopant is a compound having a noncyclic aminophosphazene scaffold;
is deposited together with an organic electron transport material within a layer, and the n-dopant and the electron transport material are reacted.

2. Method according to Claim 1, wherein the substituents R¹ - R⁴ independently of one another are selected from the group of R' comprising a bond, C1-C20 substituted or unsubstituted alkyl, cycloalkyl;
R⁵ is selected from NR'₂ and [-N=P(NR'₂)₂-]ₙ where n = 1 to 5; and
R⁶ is selected from the group of R' and [-P(NR'₂)₂=N-]ₙ where n = 1 to 5, it being possible for the substituents independently of one another to be joined to form cyclic units.

3. Method according to Claim 1 or 2, wherein the layer thickness concentration (volume%) of the n-dopant in a layer is ≥ 0.01% and ≤ 30%.

4. Method according to any of the preceding claims, wherein the number of aminophosphazene groups in the dopant is ≥ 2 and ≤ 7.

5. Method according to any of the preceding claims, wherein the dopant comprises at least one compound of formulae 3-28 below: 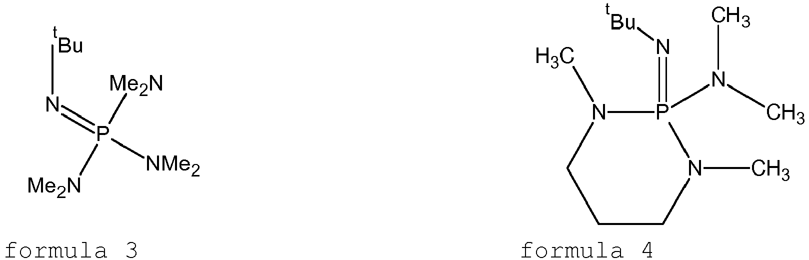 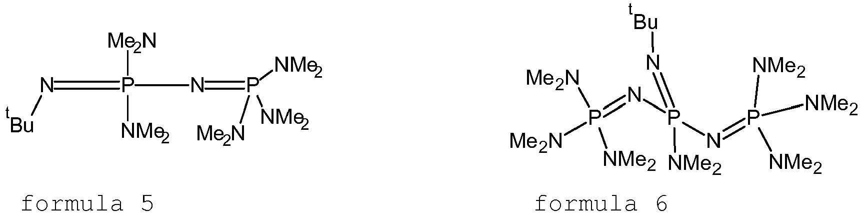 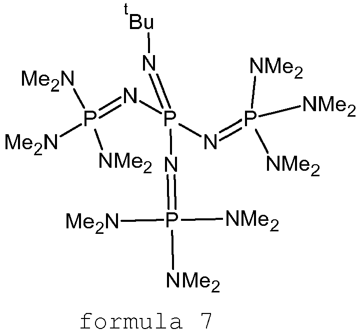 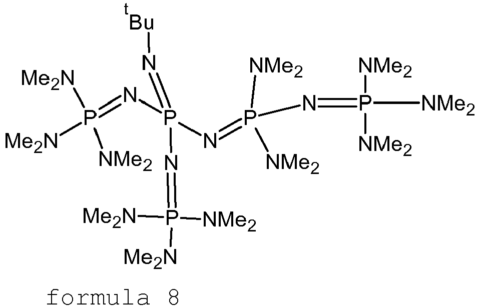 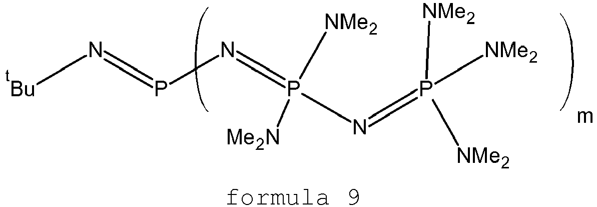 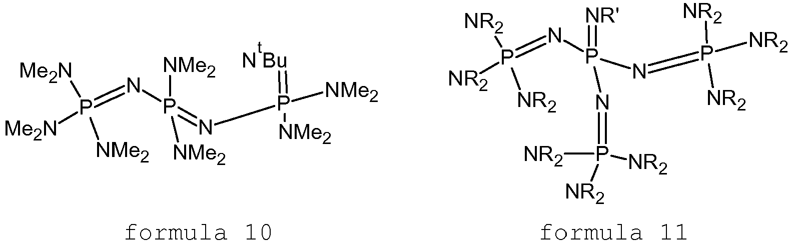 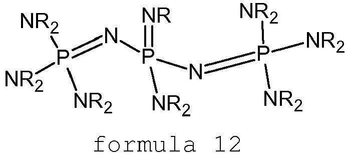 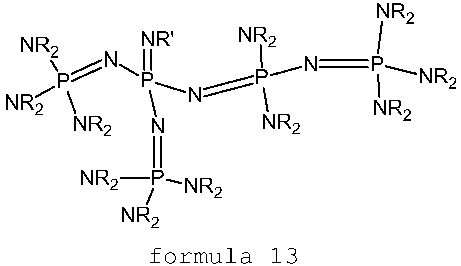 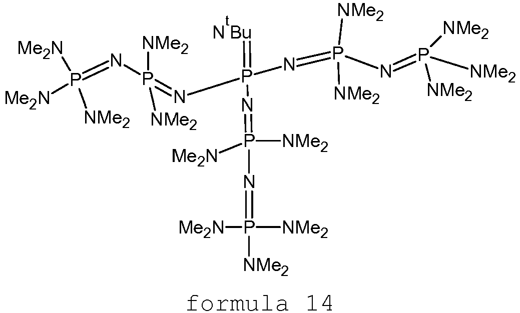 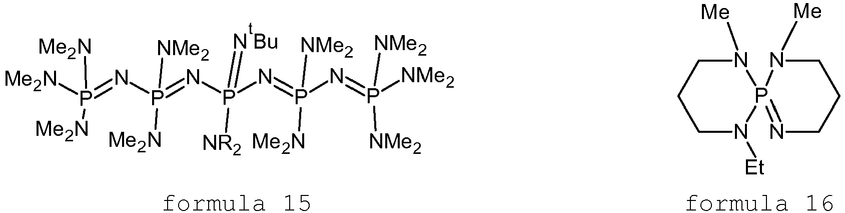 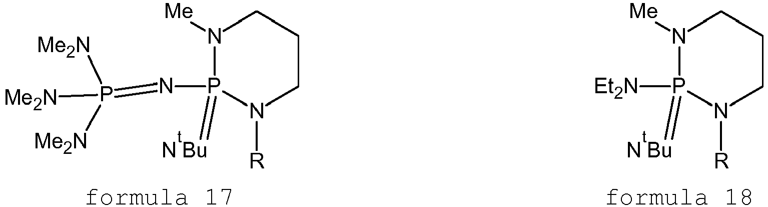 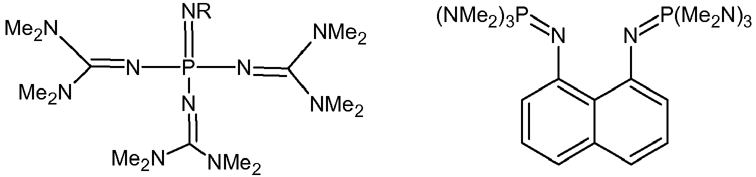 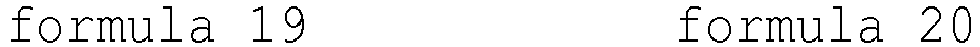 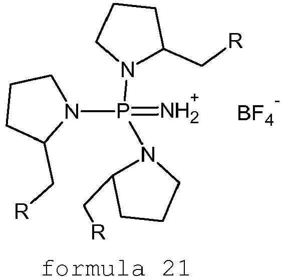 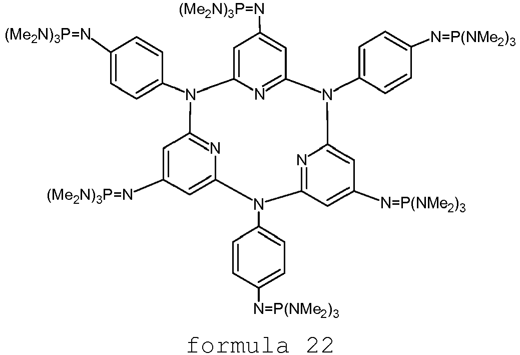 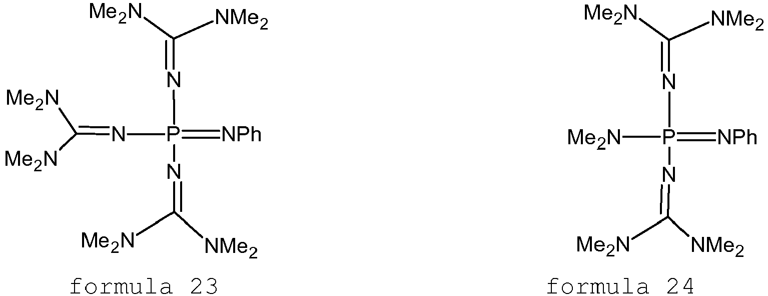 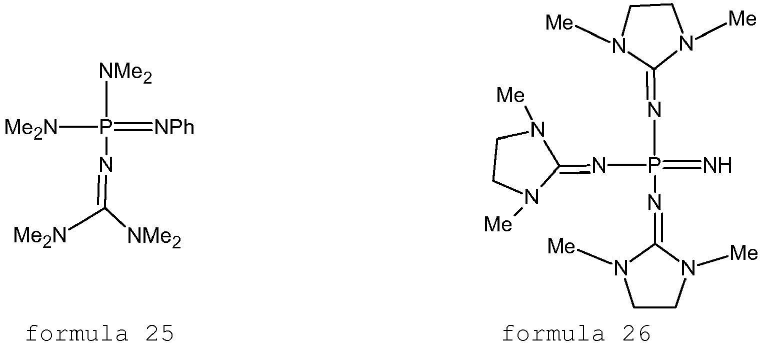 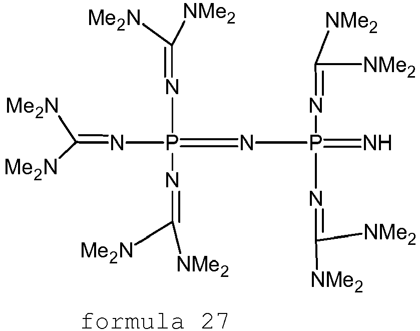 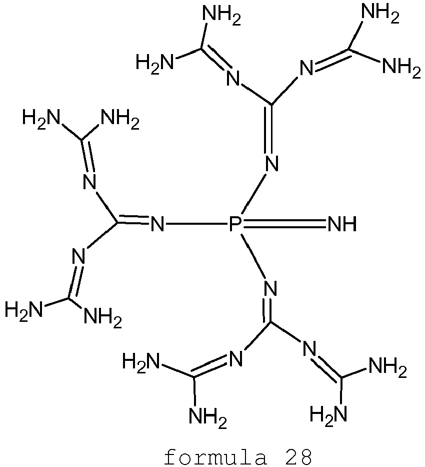 where m in formula 9 is ≥ 1 and ≤ 5.

6. Method according to any of the preceding claims, wherein the organic electron transport material is selected from the group encompassing 2,2',2"-(1,3,5-benzinetriyl)tris(1-phenyl-1-H-benzimidazole), 2-(4-biphenylyl)-5-(4-tert-butylphenyl)-1,3,4-oxadiazole; 2,9-dimethyl-4,7-diphenyl-1,10-phenanthroline (BCP), 8-hydroxyquinolinolatolithium; 4-(naphthalen-1-yl)-3,5-diphenyl-4H-1,2,4-triazole; 1,3-bis[2-(2,2'-bipyridine-6-yl)-1,3,4-oxadiazo-5-yl]benzene; 4,7-diphenyl-1,10-phenanthroline (BPhen); 3-(4-biphenylyl)-4-phenyl-5-tert-butylphenyl-1,2,4-triazole; bis(2-methyl-8-quinolinolate)-4-(phenylphenolato)aluminum; 6,6'-bis[5-(biphenyl-4-yl)-1,3,4-oxadiazo-2-yl]-2,2'-bipyridyl; 2-phenyl-9,10-di(naphthalen-2-yl)anthracene; 2,7-bis[2-(2,2'-bipyridine-6-yl)-1,3,4-oxadiazo-5-yl]-9,9-dimethylfluorene; 1,3-bis[2-(4-tert-butylphenyl)-1,3,4-oxadiazo-5-yl]benzene; 2-(naphthalen-2-yl)-4,7-diphenyl-1,10-phenanthroline; 2,9-bis(naphthalen-2-yl)-4,7-diphenyl-1,10-phenanthroline; tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; phenyldipyrenyl-phosphine oxide; 3,3',5,5'-tetra[(m-pyridyl)phen-3-yl]biphenyl; 1,3,5-tris[(3-pyridyl)phen-3-yl]benzene; 4,4'-bis(4,6-diphenyl-1,3,5-triazin-2-yl)biphenyl; 1,3-bis[3,5-di(pyridin-3-yl)phenyl]benzene; diphenylbis(4-(pyridin-3-yl)phenyl)silane; 3,5-di(pyren-1-yl)pyridine; 1,3,5-tri(p-pyrid-3-ylphenyl)benzene; 2,4,6-tris(3'-(pyridin-3-yl)biphenyl-3-yl)-1,3,5-triazine; naphthalenetetracarboxylic dianhydride and its imides; perylenetetracarboxylic dianhydride and its imides; materials based on siloles, having a silacyclopentadiene unit.

7. N-conducting organic-electrical layer, produced by a method according to any of Claims 1-6.

8. Organic-electrical component, **characterized in that** the component comprises an n-conducting organic-electrical layer according to Claim 7.

## Revendications

1. Procédé de fabrication de couches électro-conductrices organiques de type n, **caractérisé en ce qu'**un agent de dopage de type n a la formule 2 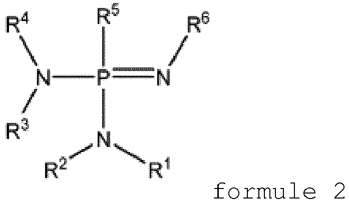 dans laquelle
R¹ à R⁴ sont sélectionnés indépendamment parmi le groupe des R comprenant une liaison, H, D, un alkyle, un cycloalkyle, un hétéroalkyle, un hétérocycloalkyle saturé ou insaturé en C1 à C60; un aryle, un alkylaryle, un hétéroaryle en C1 à C60,
R⁵ est sélectionné parmi NR₂ et [-N=P(NR₂)₂-]ₙ, dans lequel n = 1 à 5, et
R⁶ est sélectionné parmi le groupe comprenant R et [-P(NR₂)₂=N-]ₙ, n étant égal à un nombre de 1 à 5, dans lequel les substituants peuvent être liés indépendamment à des unités cycliques,
l'agent de dopage étant un composé ayant un squelette d'aminophosphazène non cyclique, et
ledit agent de dopage de type n, ensemble avec une matière organique de transport d'électrons, sont déposés à l'intérieur d'une couche et l'agent de dopage de type n et la matière de transport d'électrons sont mis en réaction.

2. Procédé selon la revendication 1, dans lequel les substituants R¹ à R⁴ sont sélectionnés indépendamment parmi le groupe R' comprenant une liaison, un alkyl, un cycloalkyle saturé ou insaturé en C1 à C20,
R⁵ est sélectionné parmi NR'₂ et [-N=P(NR'₂)₂-]ₙ, n étant un nombre de 1 à 5, et
R⁶ est sélectionné parmi le groupe R' et [-P(NR'₂)₂=N-]ₙ, n étant un nombre de 1 à 5, dans lequel les substituants peuvent être liés indépendamment à des unités cycliques.

3. Procédé selon la revendication 1 ou 2, dans lequel la concentration d'épaisseur de couche (en % en volume) de l'agent de dopage de type n dans une couche est ≥ 0,01 % et ≤ 30 %.

4. Procédé selon l'une des revendications précédentes, dans lequel le nombre des groupes aminophosphazène dans l'agent de dopage est ≥ 2 et ≤ 7.

5. Procédé selon l'une des revendications précédentes, dans lequel l'agent de dopage comprend au moins un composé ayant une des formules suivantes 3 à 28 : 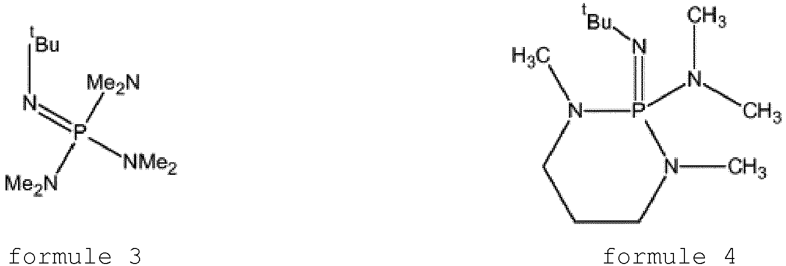 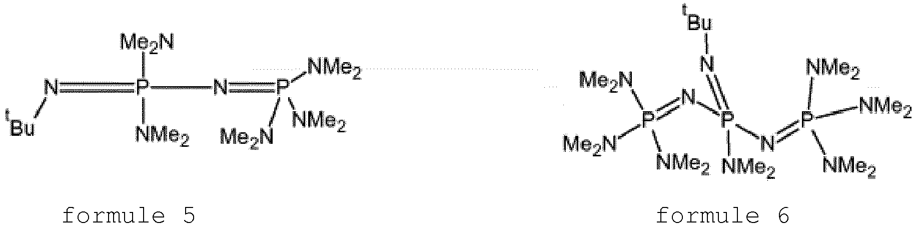 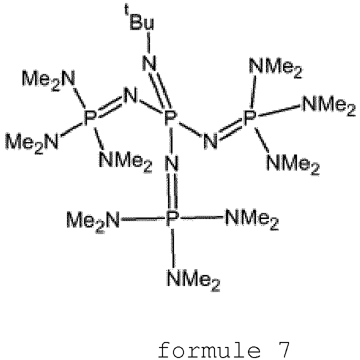 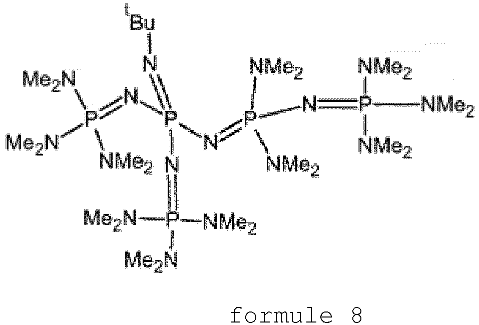 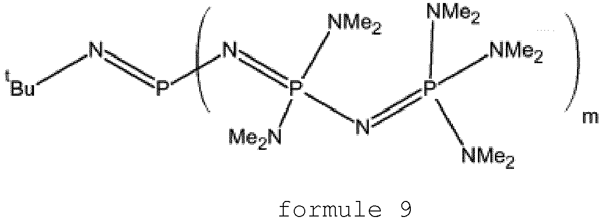 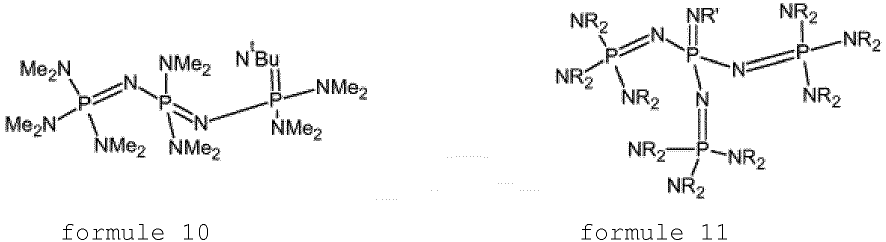 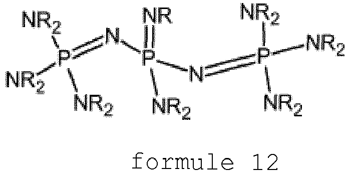 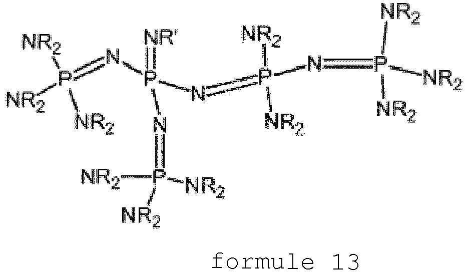 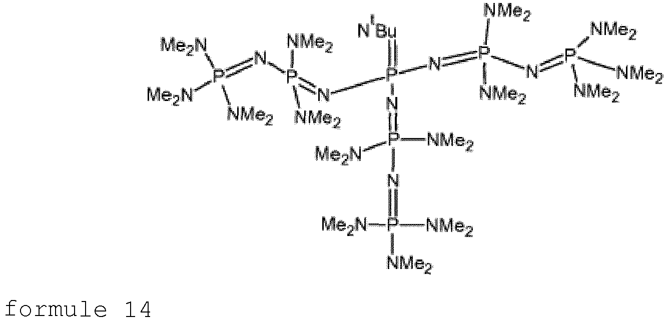 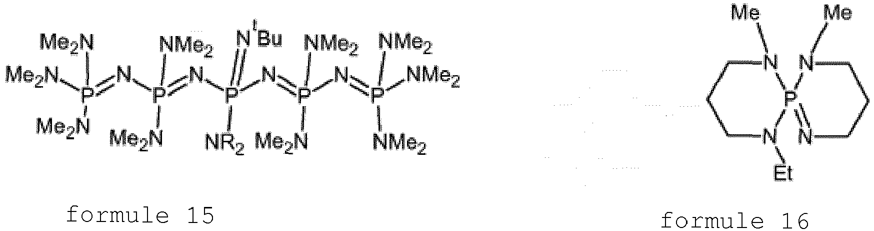 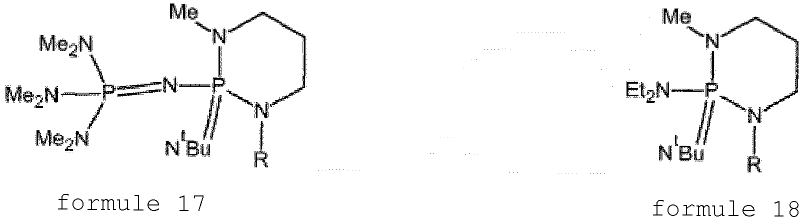 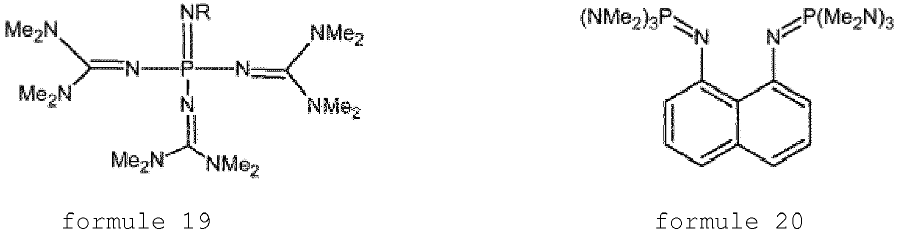 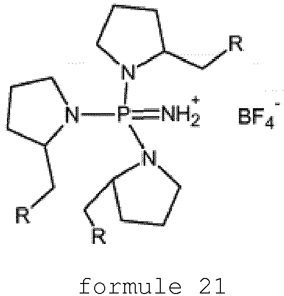 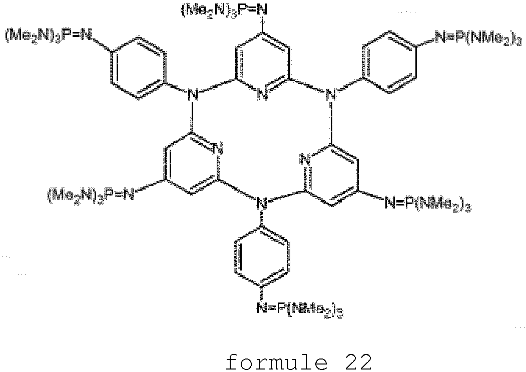 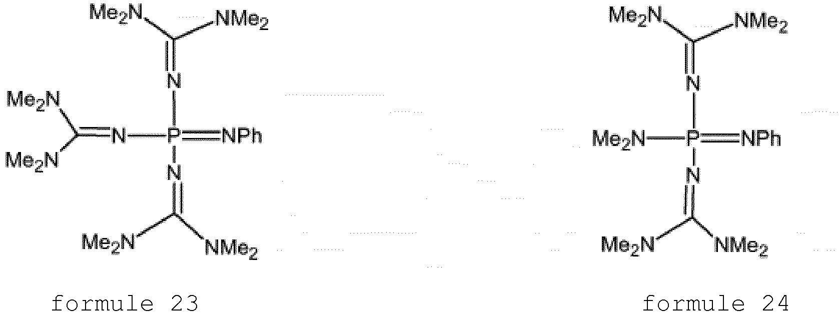 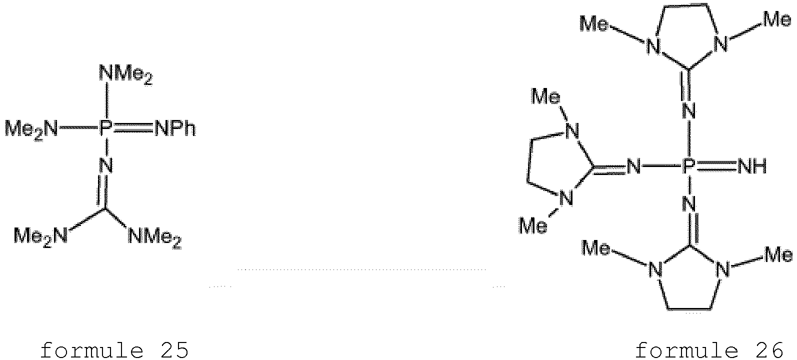 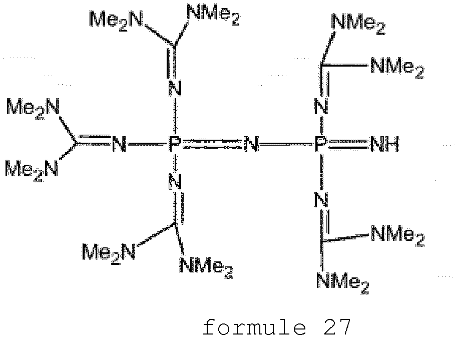 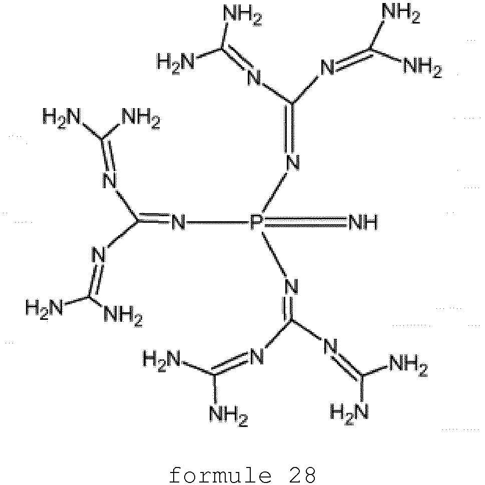 dans lesquelles m dans la formule 9 est ≥ 1 et ≤ 5.

6. Procédé selon l'une des revendications précédentes, dans lequel la matière organique de transport d'électrons est sélectionnée parmi le groupe comprenant 2,2',2"-(1,3,5-benzinetriyl)-tris(1-phényl-1-H-benzimidazole), 2-(4-biphénylyl)-5-(4-tert-butylphényl)-1,3,4-oxadiazole, 2,9-diméthyl-4,7-diphényl-1,10-phénanthroline (BCP), 8-hydroxyquinolinolato-lithium, 4-(naphthalén-1-yl)-3,5-diphényl-4H-1,2,4-triazole, 1,3-Bis[2-(2,2'-bipyridin-6-yl)-1,3,4-oxadiazo-5-yl]benzène, 4,7-diphényl-1,10-phénanthroline (BPhen), 3-(4-biphénylyl)-4-phényl-5-tert-butylphényl-1,2,4-triazole, bis(2-méthyl-8-quinolinolate)-4-(phénylphénolato)aluminium, 6,6'-Bis[5-(biphényl-4-yl)-1,3,4-oxadiazo-2-yl]-2,2'-bipyridyl, 2-phényl-9,10-di(naphthalén-2-yl)-anthracène, 2,7-bis[2-(2,2'-bipyridin-6-yl)-1,3,4-oxadiazo-5-yl]-9,9-diméthylfluorène, 1,3-bis[2-(4-tert-butylphényl)-1,3,4-oxadiazo-5-yl]benzène, 2-(naphthalén-2-yl)-4,7-diphényl-1,10-phénanthroline, 2,9-bis(naphthalén-2-yl)-4,7-diphényl-1,10-phénanthroline, tris(2,4,6-triméthyl-3-(pyridin-3-yl)phényl)borane, 1-méthyl-2-(4-(naphthalén-2-yl)phényl)-1H-imidazo[4,5-f][1,10]phénanthroline, phényl-dipyrénylphosphine oxyde, 3,3',5,5'-tétra[(m-pyridyl)-phén-3-yl]biphényl, 1,3,5-tris[(3-pyridyl)-phén-3-yl]benzène, 4,4'-bis(4,6-diphényl-1,3,5-triazin-2-yl)biphényl, 1,3-bis[3,5-di(pyridin-3-yl)phényl]benzène, diphénylbis(4-(pyridin-3-yl)phényl)silane, 3,5-di(pyrén-1-yl)pyridine, 1,3,5-tri(p-pyrid-3-yl-phényl)benzène, 2,4,6-tris(3'-(pyridin-3-yl)biphényl-3-yl)-1,3,5-triazine, dianhydride d'acide naphtalènetétracarboxylique ou ses imides, dianhydride d'acide pérylènetétracarboxylique ou ses imides, et des composés à base de silols comportant un motif de silacyclopentadiène.

7. Couche organique électro-conductrice de type n, fabriquée selon un procédé selon l'une des revendications 1 à 6.

8. Composant électrique organique, **caractérisé en ce que** le composant comprend une couche organique électro-conductrice de type n selon la revendication 7.
